# EUROPEAN PATENT APPLICATION

(11) **EP 4 686 345 A1**
(43) Date of publication of application: **28.01.2026**
(21) Application number: 25167529.4
(22) Date of filing: 31.03.2025
(51) Int. Cl.: H10D 84/01, H10D 30/01, H10D 84/82, H10D 30/47, H10D 64/00

(54) **SEMICONDUCTOR DEVICE**

(30) Priority: 22.07.2024 KR 20240096442
(71) Applicant: Samsung Electronics Co., Ltd., Suwon-si, Gyeonggi-do 16677 (KR)
(72) Inventor: PARK, Junhyuk, Suwon-si (KR); HWANG, In Jun, Suwon-si (KR)
(74) Representative: Marks & Clerk LLP

(57) **Abstract**

Disclosed is a semiconductor device including main and sub-transistors. The main transistor includes: a main channel layer; a main gate electrode located on the main channel layer; a main gate semiconductor layer located between the main channel layer and the main gate electrode; source and drain electrodes located on opposite sides of the main gate electrode and connected to the main channel layer; and a field dispersion layer located on the main channel layer, and located between the main gate and the drain electrodes. The sub-transistor includes: a sub-channel layer including a drift region having two-dimensional electron gas and including a first contact portion connected with the source electrode, a second contact portion connected with the field dispersion layer, and an extension portion connecting the first and second contact portions; and a sub-gate electrode located on the extension portion of the sub-channel layer and connected with the main gate electrode.

## Description

### BACKGROUND

In modern society, semiconductor devices are closely related to our daily lives. In particular, power semiconductor devices are becoming increasingly important in various fields including transportation, such as electric vehicles, railways, and electric trams, renewable energy systems, such as solar energy generation and wind power generation, and mobile devices. Power semiconductor devices are semiconductor devices used to handle high voltages or high currents, perform functions such as power conversion, and control large power systems and high-power electronic devices. Power semiconductor devices can handle high power and durability and thus are capable of handling large amounts of current and withstanding high voltages. For example, power semiconductor devices may handle voltages of hundreds to thousands of volts and currents of tens to thousands of amperes. Power semiconductor devices may improve the efficiency of electrical energy by minimizing power losses. Power semiconductor devices may also operate reliably in diverse environments, such as high temperatures.

These power semiconductor devices may be categorized by material, and may include, for example, SiC power semiconductor devices and GaN power semiconductor devices. By utilizing SiC or GaN in place of traditional silicon (Si) to manufacture power semiconductor devices, the disadvantages of silicon, such as its instability at high temperatures, may be overcome. SiC power semiconductor devices are resistant to high temperatures and have low power loss, and may be suitable for electric vehicles, renewable energy systems, and more. GaN power semiconductor devices are relatively expensive compared to SiC power semiconductor devices, but are efficient in terms of speed, and may be suitable for fast charging of mobile devices.

### SUMMARY

An aspect of the invention is described at Claim 1.

In a first general aspect, a semiconductor device includes: a main transistor; and a sub-transistor connected to one end of the main transistor, in which the main transistor includes: a main channel layer; a main gate electrode located on the main channel layer; a main gate semiconductor layer located between the main channel layer and the main gate electrode; a source electrode and a drain electrode located on opposite sides of the main gate electrode and connected to the main channel layer; and a field dispersion layer located on the main channel layer, and located between the main gate electrode and the drain electrode, and the sub-transistor includes: a sub-channel layer including a drift region having two-dimensional electron gas, and including a first contact portion connected with the source electrode, a second contact portion connected with the field dispersion layer, and an extension portion connecting the first contact portion and the second contact portion; and a sub-gate electrode located on the extension portion of the sub-channel layer, and connected with the main gate electrode.

In a second general aspect, a semiconductor device includes: a main channel layer; a gate electrode located on the main channel layer; a gate semiconductor layer located between the main channel layer and the gate electrode; a source electrode and a drain electrode located on opposite sides of the gate electrode and connected to the main channel layer; a field dispersion layer located on the main channel layer, and located between the gate electrode and the drain electrode; and a sub-channel layer including a drift region having two-dimensional electron gas, and including a first contact portion connected with the source electrode, a second contact portion connected with the field dispersion layer, and an extension portion connecting the first contact portion and the second contact portion, in which the gate electrode overlaps the extension portion of the sub-channel layer in a thickness direction of the sub-channel layer.

In a third general aspect, a semiconductor device includes: a main transistor; and a sub-transistor connected to one end of the main transistor, in which the main transistor includes: a main channel layer including GaN; a barrier layer located on the main channel layer and including AlGaN; a main gate electrode located on the barrier layer; a main gate semiconductor layer located between the main channel layer and the main gate electrode and including GaN doped with p-type impurities; a source electrode and a drain electrode located on opposite sides of the main gate electrode and connected to the main channel layer; a first protective layer located on the main gate electrode and the barrier layer; and a field dispersion layer located on the first protective layer, and located between the main gate electrode and the drain electrode, and the sub-transistor includes: a sub-channel layer located on one side of the main channel layer, including the same material as the main channel layer, and including a first contact portion penetrating the barrier layer to be connected with the source electrode, a second contact portion penetrating the first protective layer and the barrier layer to be connected with the field dispersion layer, and an extension portion connecting the first contact portion and the second contact portion; and a sub-gate electrode located on the extension portion of the sub-channel layer, connected to the main gate electrode, and including the same material as the main gate electrode.

In some implementations, the semiconductor devices of the present disclosure have stable electrical characteristics and improved reliability compared to conventional semiconductor devices.

At least some of the above and other features of the invention are set out in the claims.

### BRIEF DESCRIPTION OF THE DRAWINGS

FIGS. 1 and 2 are circuit diagrams illustrating an example of a semiconductor device.
FIG. 3 is a top plan view illustrating the semiconductor device of FIGS. 1 and 2.
FIG. 4 and FIG. 5 are cross-sectional views taken along line A-A' of FIG. 3.
FIG. 6 is a cross-sectional view taken along line B-B' of FIG. 3.
FIG. 7 is a cross-sectional view taken along line C-C' of FIG. 3.
FIG. 8 is a cross-sectional view taken along line D-D' of FIG. 3.
FIG. 9 is an example of a cross-sectional view corresponding to A-A' of FIG. 3.
FIG. 10 is an example of a cross-sectional view corresponding to B - B' of FIG. 3.
FIG. 11 is a cross-sectional view corresponding to D - D' of FIG. 3.
FIG. 12 to FIG. 17 are top plan views illustrating examples of semiconductor devices.
FIG. 18 is a circuit diagram illustrating an example of a semiconductor device.
FIG. 19 is a top plan view illustrating the semiconductor device of FIG. 18.
FIG. 20 is a cross-sectional view taken along line E-E' of FIG. 19.
FIG. 21 is a cross-sectional view taken along line F-F' of FIG. 19.
FIG. 22 is a top plan view illustrating the semiconductor device of FIG. 18.
FIG. 23 is a cross-sectional view taken along line G-G' of FIG. 22.
FIG. 24 is a top plan view of an example of an intermediate operation illustrating a method of manufacturing a semiconductor device.
FIG. 25 is an example of a cross-sectional view taken along lines H-H' and I-I' of FIG. 24.
FIG. 26 is another example of a cross-sectional view corresponding to H-H' and I-I' of FIG. 24.
FIG. 27 is a top plan view of an example of another intermediate operation illustrating the method of manufacturing the semiconductor device.
FIG. 28 is a cross-sectional view taken along lines J-J' and K-K' of FIG. 27.
FIG. 29 is a top plan view of an example of another intermediate operation illustrating the method of manufacturing the semiconductor device.
FIG. 30 is a cross-sectional view taken along lines L-L' and M-M' of FIG. 29.

The drawings and description are to be regarded as illustrative in nature and not restrictive. Like reference numerals designate like elements throughout the specification.

### DETAILED DESCRIPTION

In the following detailed description, only certain example embodiments of the present disclosure have been illustrated and described, simply by way of illustration. The present disclosure may be variously implemented and is not limited to the following example embodiments.

In addition, the size and thickness of each configuration illustrated in the drawings are arbitrarily illustrated for understanding and ease of description, but the present disclosure is not limited thereto. In the drawings, the thickness of layers, films, panels, regions, etc., are exaggerated for clarity. In the drawings, for understanding and ease of description, the thickness of some layers and areas is exaggerated.

Further, it will be understood that when an element such as a layer, film, region, or substrate is referred to as being "on" another element, it may be directly on the other element or intervening elements may also be present. In contrast, when an element is referred to as being "directly on" another element, there are no intervening elements present. Further, when an element is "on" a reference portion, the element is located above or below the reference portion, and it does not necessarily mean that the element is located "above" or "on" in a direction opposite to gravity.

In addition, unless explicitly described to the contrary, the word "comprise", and variations such as "comprises" or "comprising", will be understood to imply the inclusion of stated elements but not the exclusion of any other elements.

Further, in the entire specification, when it is referred to as "on a plan view", it means when a target part is viewed from above, and when it is referred to as "in a cross-sectional view", it means when the cross-section obtained by cutting a target part vertically is viewed from the side.

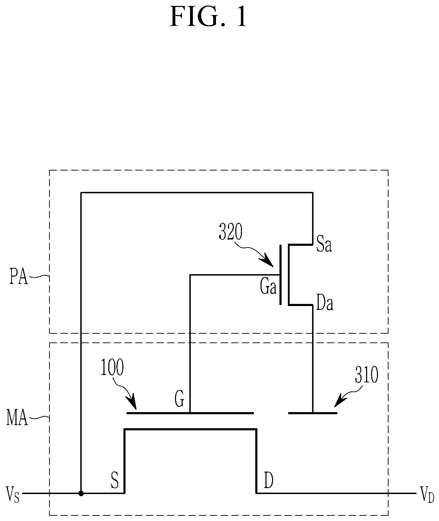

FIG. 1 is a circuit diagram illustrating an example of a semiconductor device.

First, as illustrated in FIG. 1, a semiconductor device includes a main device region MA including a main transistor 100 and a peripheral circuit region PA including a sub-transistor 320.

The main transistor 100 may be located within the main device region MA. For example, the main transistor 100 of the semiconductor device may be a normally off high electron mobility transistor (HEMT). However, the present disclosure is not limited thereto, and the main transistor 100 of the semiconductor device may be a normally on high electron mobility transistor. That is, in this example, the main device region MA may refer to the region where the main transistor 100 is disposed.

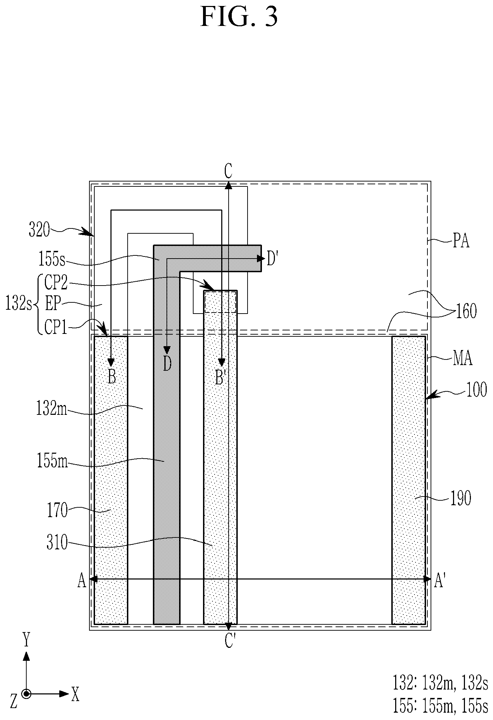

In this example, the main transistor 100 may include a gate electrode G, a first electrode D, and a second electrode S. The main transistor 100 may control the drain-to-source current between the first electrode D and the second electrode S according to a gate signal applied to the gate electrode G. For example, when a turn-on signal is applied to the gate electrode G of the main transistor 100, current may flow from the first electrode D to the second electrode S. The first electrode D may be supplied with a first supply voltage V_{D}, and the second electrode S may be supplied with a second supply voltage V_{S}. The magnitude of the second supply voltage V_{S} may be smaller than the magnitude of the first supply voltage V_{D}. For example, the second supply voltage V_{S} may be a ground voltage. Here, the first electrode D may refer to a drain electrode (190 in FIG. 3) of the main transistor 100, and the second electrode S may refer to a source electrode (170 in FIG. 3) of the main transistor 100. Further, the first supply voltage V_{D} may mean a voltage supplied to the drain electrode (190 in FIG. 3) of the main transistor 100. The second supply voltage V_{S} may mean a voltage supplied to the source electrode (170 in FIG. 3) of the main transistor 100. In the implementations illustrated herein, the phrases "source electrode" and "drain electrode" may be understood to mean a source terminal region and a drain terminal region, respectively, of either of the main transistor 100 and sub-transistor 320.

The main transistor 100 may include a field dispersion layer 310. The field dispersion layer 310 may be located between the gate electrode G and the first electrode D of the main transistor 100 and may serve to dissipate an electric field that is concentrated around the gate electrode G of the main transistor 100. Accordingly, the leakage current in the main transistor 100 may be reduced, and the breakdown voltage of the main transistor 100 may be increased. This will be described in more detail with reference to FIG. 3 below.

The peripheral circuit region PA of the semiconductor device may include elements electrically connected to the main transistor 100. Specifically, the peripheral circuit region PA of the semiconductor device may include a sub-transistor 320 electrically connected to one end of the main transistor 100. In this example, the sub-transistor 320 may serve to electrically isolate the second electrode S of the main transistor 100 from the field dispersion layer 310, or to discharge charge within the field dispersion layer 310 of the main transistor 100 to the second electrode S of the main transistor 100. However, the present disclosure is not limited thereto, and the peripheral circuit region PA may further include passive elements, such as capacitors or inductors, in addition to the sub-transistor 320, or may further include active elements, such as integrated circuit (IC) chips. As another example, the peripheral circuit region PA may further include a current divider, a voltage divider, a voltage clipper, a protection element of the main transistor 100, and the like. In this example, the peripheral circuit region PA may refer to the region where the sub-transistor 320 is disposed.

In this example, the sub-transistor 320 may include a gate electrode Ga, a first electrode Da, and a second electrode Sa. The sub-transistor 320 may control a drain-to-source current between the first electrode Da and the second electrode Sa according to a gate signal applied to the gate electrode Ga.

The sub-transistor 320 may be electrically connected with one end of the main transistor 100. For example, the first electrode Da of the sub-transistor 320 may be electrically connected to the field dispersion layer 310, and the second electrode Sa of the sub-transistor 320 may be electrically connected to the second electrode S of the main transistor 100. The second electrode Sa of the sub-transistor 320 may be electrically connected with a second power source supplying a second supply voltage V_{S}.

Further, the gate electrode Ga of the sub-transistor 320 may be electrically connected with the gate electrode G of the main transistor 100. Accordingly, the same signal may be applied to the gate electrode Ga of the sub-transistor 320 and the gate electrode G of the main transistor 100. For example, when a turn-on signal is applied to the gate electrode G of the main transistor 100, the same turn-on signal may be applied to the gate electrode Ga of the sub-transistor 320. Furthermore, when a turn-off signal is applied to the gate electrode G of the main transistor 100, the same turn-off signal may be applied to the gate electrode Ga of the sub-transistor 320. Thus, when the turn-on signal is applied to the gate electrode G of the main transistor 100, a current may flow from the first electrode D to the second electrode S of the main transistor 100, and a current may flow from the first electrode Da to the second electrode Sa of the sub-transistor 320.

Here, the first electrode Da of the sub-transistor 320 may correspond to the field dispersion layer 310 (in FIG. 3) of the sub-transistor 320, the second electrode Sa of the sub-transistor 320 may correspond to the source electrode 170 (in FIG. 3) of the main transistor 100, the gate electrode Ga of the sub-transistor 320 may correspond to the sub-gate electrode 155s (in FIG. 3) of the sub-transistor 320. The sub-transistor 320 may be divided by a separation structure 160 (in FIG. 3) and configured as a part of the main transistor 100 located in the peripheral circuit region PA, but the present disclosure is not limited thereto.

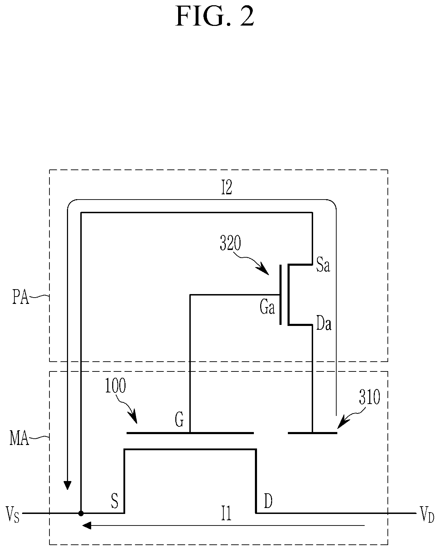

Hereinafter, a method of operating a semiconductor device will be described with reference to FIG. 2.

FIG. 2 is a circuit diagram illustrating the semiconductor device when current flows, and the main transistor 100 and the sub-transistor 320 are turned on.

Referring further to FIG. 2, in a first mode, the main transistor 100 is turned off. Then, as described above, the gate electrode G of the main transistor 100 and the gate electrode Ga of the sub-transistor 320 are electrically connected, so that when the main transistor 100 is turned off, the sub-transistor 320 may also be turned off. Thus, the field dispersion layer 310 configuring the first electrode Da of the sub-transistor 320 may be electrically isolated from the second electrode S of the main transistor 100 configuring the second electrode Sa of the sub-transistor 320. That is, the field dispersion layer 310 may be floated. The field dispersion layer 310 may serve to dissipate an electric field that is concentrated around the gate electrode G of the main transistor 100. On the other hand, when a high voltage is applied to the first electrode D of the main transistor 100, a charge may accumulate in the field dispersion layer 310 by an electric field, leakage current, or the like. When enough charge accumulates in the field dispersion layer 310, the turn-on voltage of the main transistor 100 may become unstable.

Then, in the second mode, a turn-on signal may be applied to the gate electrode G of the main transistor 100 to turn the main transistor 100 on. In this case, the current may flow from the first electrode D to the second electrode S of the main transistor 100 along a first path I1. On the other hand, as described above, the gate electrode G of the main transistor 100 and the gate electrode Ga of the sub-transistor 320 are electrically connected, so that when the main transistor 100 is turned on, the sub-transistor 320 may also be turned on. Accordingly, the current may flow from the first electrode Da to the second electrode Sa of the sub-transistor 320 together and may flow to the second electrode S of the main transistor 100 along a second path I2. Accordingly, a charge within the field dispersion layer 310 may be discharged to the second electrode S of the main transistor 100 along the second path I2. Thus, the influence of the charge in the field dispersion layer 310 may be eliminated, and the field dispersion layer 310 may effectively dissipate the electric field concentrated around the gate electrode G of the main transistor 100, and the reliability of the semiconductor device may be improved.

Hereinafter, an example of the semiconductor device will be described with reference to FIG. 3. FIG. 3 is a top plan view illustrating the semiconductor device.

Referring to FIG. 3, the peripheral circuit region PA of the semiconductor device is spaced apart from the main device region MA. For example, the peripheral circuit region PA may be spaced apart from the main device region MA in a second direction (Y direction), but the peripheral circuit region PA is not limited thereto. As another example, the peripheral circuit region PA may be spaced apart from the main device region MA in a first direction (X direction), or the peripheral circuit region PA may surround a lateral surface of the main device region MA. Various other modifications are of course possible. Within the main device region MA, the main transistor 100 may be located, and the peripheral circuit region PA may include the sub-transistor 320 that is electrically connected to one end of the main transistor 100.

The semiconductor device may include a channel layer 132 with two-dimensional electron gas (2DEG) 134 located therein, a gate electrode 155 located above the channel layer 132, a gate semiconductor layer located between the channel layer 132 and the gate electrode 155, a source electrode 170 and a drain electrode 190 located on opposite sides of the gate electrode 155 above the channel layer 132, and a field dispersion layer 310 located between the gate electrode 155 and the drain electrode 190 above the channel layer 132.

In this example, the channel layer 132, the gate electrode 155, and the gate semiconductor layer may be located in the main device region MA and the peripheral circuit region PA. Hereinafter, for ease of description, the portion of the channel layer 132 located in the main device region MA may be referred to as a main channel layer 132m and the portion of the channel layer 132 located in the peripheral circuit region PA may be referred to as a sub-channel layer 132s. Further, the portion of the gate electrode 155 located in the main device region MA may be referred to as a main gate electrode 155m, and the portion of the gate electrode 155 located in the peripheral circuit region PA may be referred to as a sub-gate electrode 155s. Further, the portion of the gate semiconductor layer located in the main device region MA may be referred to as a main gate semiconductor layer 152m, and the portion of the gate semiconductor layer located in the peripheral circuit region PA may be referred to as a sub-gate semiconductor layer 152s.

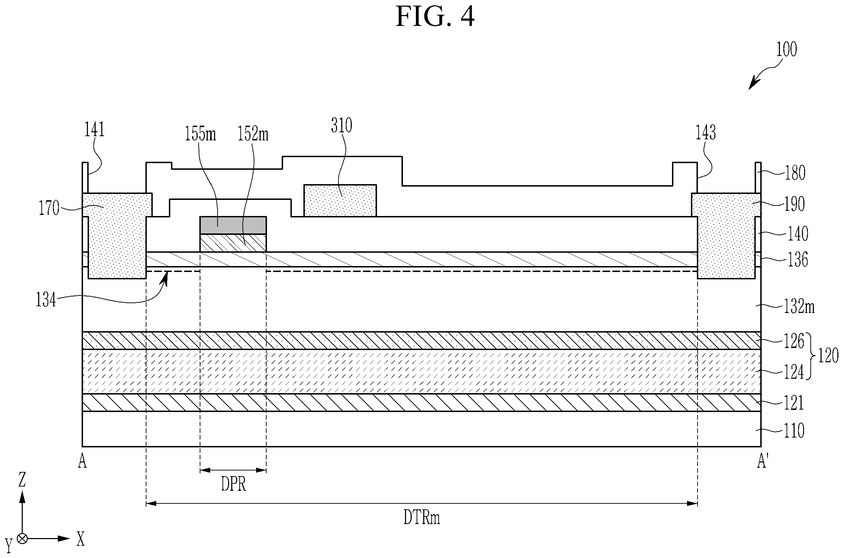

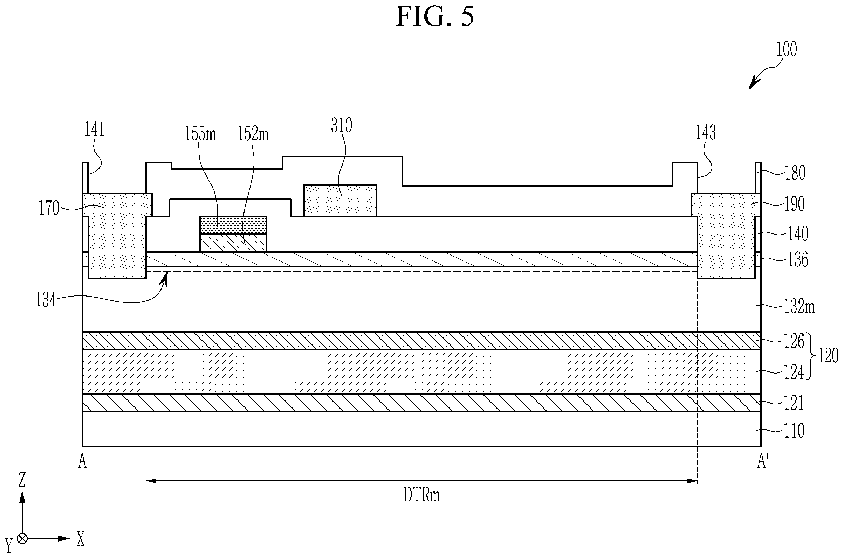

Hereinafter, the main transistor of the semiconductor device will be described with reference to FIGS. 4 and 5.

FIGS. 4 and 5 are cross-sectional views taken along lines A-A' of FIG. 3. FIG. 4 illustrates a case in which the semiconductor device is in an off state, and FIG. 5 illustrates a case in which the semiconductor device is in an on state.

Referring further to FIG. 4, the main transistor 100 of the semiconductor device includes the main channel layer 132m, the main gate electrode 155m located above the main channel layer 132m, the main gate semiconductor layer 152m located between the main channel layer 132m and the main gate electrode 155m, the source electrode 170 and the drain electrode 190 spaced apart from each other on the main channel layer 132m, and the field dispersion layer 310 located above the main channel layer 132m and located between the main gate electrode 155m and the drain electrode 190.

The main channel layer 132m is a layer that forms a channel between the source electrode 170 and the drain electrode 190, and the two dimensional electron gas (2DEG) 134 may be located within the main channel layer 132m. The two-dimensional electron gas 134 is a charge transport model used in solid state physics and refers to a bunch of electrons that move freely in two dimensions (e.g., in the x-y plane direction), but cannot in one other dimension (e.g., in the z direction), and are tightly confined within two dimensions. In other words, the two-dimensional electron gas 134 may exist in a two-dimensional planar form within a three-dimensional space. Two-dimensional electron gases 134 are commonly found in semiconductor heterojunction structures and may be generated at the interface between a main channel layer 132m and a barrier layer 136 in a semiconductor device. For example, the two-dimensional electron gas 134 may be generated in a portion of the main channel layer 132m adjacent to the barrier layer 136. In this example, the main channel layer 132m may refer to a portion of the channel layer 132 located in the main device region MA.

The main channel layer 132m may include one or more materials selected from group III-V materials, for example, nitrides including Al, Ga, In, B, or combinations thereof. The main channel layer 132m may be a single layer or multiple layers. The main channel layer 132m may be AlₓIn_{y}Ga_{1-x-y}N (0≤x≤1, 0≤y≤1, x+y≤1). For example, the main channel layer 132m may include AlN, GaN, InN, InGaN, AlGaN, AlInN, AlInGaN, or a combination thereof. The main channel layer 132m may be an impurity doped layer or an impurity undoped layer. The main channel layer 132m may have a thickness of about a few hundred nm or less.

The main channel layer 132m may be located above the substrate 110, and a seed layer 121 and a buffer layer 120 may be located between the substrate 110 and the main channel layer 132m.

The substrate 110, the seed layer 121, and the buffer layer 120 form the main channel layer 132m and may be omitted in some cases. For example, when a substrate formed of GaN is used as the main channel layer 132m, at least one of the substrate 110, the seed layer 121, and the buffer layer 120 may be omitted. Considering that the substrate formed of GaN is relatively expensive, the substrate 110 formed of Si may be used to grow the main channel layer 132m including GaN. In this case, growing the main channel layer 132m directly on the substrate 110 may be difficult because the lattice structure of Si and the lattice structure of GaN are different. Accordingly, the seed layer 121 and the buffer layer 120 may be grown on the substrate 110 first, and then the main channel layer 132m may be grown on the buffer layer 120. Additionally, at least one of the substrate 110, the seed layer 121, and the buffer layer 120 may be removed from the final structure of the semiconductor device after it is used in the manufacturing process. It will be understood that other materials besides Si, or in addition to Si, may be used and the use of Si for the substrate 110 is an example. The growing of GaN is also an example, and other materials may be used.

The substrate 110 may include a semiconductor material. For example, the substrate 110 may include sapphire, Si, SiC, AlN, GaN, or combinations thereof. The substrate 110 may also be a silicon on insulator (SOI) substrate. However, the material of the substrate 110 is not limited to this, and any commonly used substrate may be applied. In some cases, the substrate 110 may include an insulating material. For example, several layers, including the main channel layer 132m, may be formed first on top of a semiconductor substrate, and then the semiconductor substrate may be removed and replaced with an insulating substrate.

The seed layer 121 may be located directly on the substrate 110. However, the present disclosure is not limited thereto, and any other predetermined layers may be further located between the substrate 110 and the seed layer 121. The seed layer 121 is a layer that serves as a seed for growing the buffer layer 120 and may be formed of a crystal lattice structure that serves as a seed for the buffer layer 120. The buffer layer 120 may be located directly on the seed layer 121. However, the present disclosure is not limited thereto, and any other predetermined layer may be further located between the seed layer 121 and the buffer layer 120. The seed layer 121 may include one or more materials selected from group III-V materials, for example, nitrides including Al, Ga, In, B, or combinations thereof. The seed layer 121 may be AlₓIn_{y}Ga_{1-x-y}N (0≤x≤1, 0≤y≤1, x+y≤1). For example, the seed layer 121 may include AlN, GaN, InN, InGaN, AlGaN, AlInN, AlInGaN, or combinations thereof.

The buffer layer 120 may be located on the seed layer 121. The buffer layer 120 may be located between the seed layer 121 and the main channel layer 132m. The buffer layer 120 may be a layer to mitigate differences in lattice constants and thermal expansion coefficients between the seed layer 121 and the main channel layer 132m, or to prevent leakage current from flowing through the main channel layer 132m. The buffer layer 120 may include one or more materials selected from group III-V materials, for example, nitrides including Al, Ga, In, B, or combinations thereof. The buffer layer 120 may be AlₓIn_{y}Ga_{1-x-y}N (0≤x≤1, 0≤y≤1, x+y≤1). For example, the buffer layer 120 may include AlN, GaN, InN, InGaN, AlGaN, AlInN, AlInGaN, or combinations thereof.

The buffer layer 120 of the semiconductor device may include a superlattice layer 124 located on the seed layer 121, and a high-resistance layer 126 located on the superlattice layer 124. The superlattice layer 124 and the high-resistance layer 126 may be sequentially located on the substrate 110.

The superlattice layer 124 may be located on the seed layer 121. The superlattice layer 124 may be located directly on the seed layer 121. However, the present disclosure is not limited thereto, and any other predetermined layer may be further located between the seed layer 121 and the superlattice layer 124. The superlattice layer 124 is a layer for mitigating differences in lattice constants and thermal expansion coefficients between the substrate 110 and the main channel layer 132m, and thus mitigating tensile stresses and compressive stresses generated between the substrate 110 and the main channel layer 132m, and mitigating stresses between all layers formed by growth in the final structure of the semiconductor device. The superlattice layer 124 may include one or more materials selected from group III-V materials, for example, nitrides including Al, Ga, In, B, or combinations thereof. The superlattice layer 124 may be AlₓIn_{y}Ga_{1-x-y}N (0≤x≤1, 0≤y≤1, x+y≤1). For example, the superlattice layer 124 may include AlN, GaN, InN, InGaN, AlGaN, AlInN, AlInGaN, or a combination thereof.

In this example, the superlattice layer 124 may be formed of multiple layers in which layers including different materials are stacked alternately. For example, the superlattice layer 124 may have the structure in which layers of AlGaN and layers of AlN are repeatedly stacked. That is, AlGaN/AlN/AlGaN/AlN/AlGaN/AlN may be stacked sequentially to form the superlattice layer. The number of AlGaN layers and GaN layers configuring the superlattice layer 124 may be varied, and the material configuring the superlattice layer 124 may be varied. As another example, the superlattice layer 124 may have a structure in which layers of AlGaN and layers of GaN are repeatedly stacked. That is, AlGaN/GaN/AlGaN/GaN/AlGaN/GaN may be stacked sequentially to form the superlattice layer. In this example, where the superlattice layer 124 includes GaN, InN, AlGaN, AlInN, InGaN, AlN, AlInGaN, or combinations thereof, the superlattice layer 124 may have n-type semiconductor properties where the concentration of electrons is greater than the concentration of holes, but the present disclosure is not limited thereto.

The high-resistance layer 126 may be located on the superlattice layer 124. The high-resistance layer 126 may be located directly on the superlattice layer 124. However, the present disclosure is not limited thereto, and any other predetermined layer may be further located between the superlattice layer 124 and the high-resistance layer 126. The high-resistance layer 126 may be located between the superlattice layer 124 and the main channel layer 132m. The high-resistance layer 126 is a layer for preventing leakage current from flowing through the main channel layer 132m, thereby preventing degradation of the semiconductor device. The high-resistance layer 126 may be made of a low-conductivity material such that the substrate 110 and the main channel layer 132m may be electrically isolated. The high-resistance layer may include one or more materials selected from group III-V materials, for example, nitrides including Al, Ga, In, B, or combinations thereof. The high-resistance layer 126 may be AlₓIn_{y}Ga_{1-x-y}N (0≤x≤1, 0≤y≤1, x+y≤1). For example, the high-resistance layer 126 may include AlN, GaN, InN, InGaN, AlGaN, AlInN, AlInGaN, or combinations thereof. The high-resistance layer 126 may be a single layer or multiple layers.

The semiconductor device may further include a barrier layer 136 located on the main channel layer 132m.

The barrier layer 136 may be located on the main channel layer 132m. The barrier layer 136 may be located directly on the main channel layer 132m. However, the present disclosure is not limited thereto, and any other predetermined layer may be further located between the main channel layer 132m and the barrier layer 136. The area of the main channel layer 132m that overlaps the barrier layer 136 between the source electrode 170 and the drain electrode 190 may be a main drift region DTRm. The main drift region DTRm may be located between the source electrode 170 and the drain electrode 190. The main drift region DTRm may refer to the region in which carriers migrate when a potential difference occurs between the source electrode 170 and the drain electrode 190.

The semiconductor device may be turned on/off depending on whether a voltage is applied to the main gate electrode 155m and/or the magnitude of the voltage applied to the main gate electrode 155m, thereby enabling or blocking carrier migration in the main drift region DTRm.

The barrier layer 136 may include one or more materials selected from group III-V materials, for example, nitrides including Al, Ga, In, B, or combinations thereof. The barrier layer 136 may be AlₓIn_{y}Ga_{1-x-y}N (0≤x≤1, 0≤y≤1, x+y≤1). The barrier layer 136 may include GaN, InN, AlGaN, AlInN, InGaN, AlN, AlInGaN, or combinations thereof. An energy band gap of the barrier layer 136 may be controlled by the composition ratio of Al and/or In. The barrier layer 136 may be doped with a predetermined impurity. In this case, the impurities doped into the barrier layer 136 may be p-type dopants that may provide holes. For example, the impurity doped in the barrier layer 136 may be magnesium (Mg). By increasing or decreasing the impurity doping concentration of the barrier layer 136, the threshold voltage, on-resistance, and the like of the semiconductor device may be adjusted.

The barrier layer 136 may include a semiconductor material having different properties from the main channel layer 132m. The barrier layer 136 may differ from the main channel layer 132m in at least one of polarization characteristics, energy band gap, and lattice constant. For example, the barrier layer 136 may include a material having a different energy band gap from the main channel layer 132m. In this case, the barrier layer 136 may have a higher energy band gap than the main channel layer 132m and may have higher electrical polarizability than the main channel layer 132m. The two-dimensional electron gas 134 may be induced in the main channel layer 132m with relatively low electrical polarizability by the barrier layer 136. In this respect, the barrier layer 136 may also be referred to as a channel supply layer or a two-dimensional electron gas supply layer. The two-dimensional electron gas 134 may be formed within a portion of the main channel layer 132m located below the interface between the main channel layer 132m and the barrier layer 136. The two-dimensional electron gas 134 may have very high electron mobility.

The barrier layer 136 may be a single layer or multiple layers. When the barrier layer 136 is multi-layered, the materials of each layer configuring the multi-layers may have different energy band gaps. In this case, the multiple layers configuring the barrier layer 136 may be disposed such that the closer the layers are to the main channel layer 132m, the larger the energy band gap.

The main gate electrode 155m may be located on the barrier layer 136. The main gate electrode 155m may overlap with a portion of the barrier layer 136 in a third direction (Z direction). The main gate electrode 155m may overlap a portion of the main drift region DTRm of the main channel layer 132m in the third direction (Z direction). The main gate electrode 155m may be located between the source electrode 170 and the drain electrode 190. The main gate electrode 155m may be spaced apart from the source electrode 170 and the drain electrode 190. For example, the main gate electrode 155m may be located closer to the source electrode 170 than the drain electrode 190. That is, the separation distance between the main gate electrode 155m and the source electrode 170 may be smaller than the separation distance between the main gate electrode 155m and the drain electrode 190, but the present disclosure is not limited thereto. In this example, the main gate electrode 155m may refer to a portion of the gate electrode 155 located in the main device region MA. Here, the third direction (Z direction) may refer to the thickness direction of the main channel layer 132m.

The main gate electrode 155m may include a conductive material. For example, the main gate electrode 155m may include a metal, a metal alloy, a conductive metal nitride, a metal silicide, a doped semiconductor material, a conductive metal oxide, or a conductive metal nitric oxide. For example, the main gate electrode 155m may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbon nitride (TiAlC-N), titanium aluminum carbide (TiAlC), titanium carbide (TiC), tantalum carbon nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The main gate electrode 155m may be a single layer or multiple layers.

In this example, the main gate electrode 155m may further include a hard mask layer located on the main gate electrode 155m. The hard mask layer may be a hard mask that was used to pattern the gate electrode material layer and/or the gate semiconductor layer during the process of forming the main gate electrode 155m. However, the hard mask layer may be removed during etching of the gate electrode material layer and/or the gate semiconductor layer based on etching conditions or post-etch cleaning conditions. In one example, the hard mask layer may include a silicon oxide, a silicon nitride, a silicon nitric oxide, or a combination thereof.

The main gate semiconductor layer 152m may be located between the barrier layer 136 and the main gate electrode 155m. That is, the main gate semiconductor layer 152m may be located on top of the barrier layer 136, and the main gate electrode 155m may be located on top of the main gate semiconductor layer 152m. The main gate electrode 155m may be in Schottky contact or ohmic contact with the main gate semiconductor layer 152m. The main gate semiconductor layer 152m may overlap the main gate electrode 155m in the third direction (Z direction). In this case, the main gate semiconductor layer 152m may completely overlap the main gate electrode 155m in the third direction (Z direction), and the main gate semiconductor layer 152m may have a top surface entirely covered by the main gate electrode 155m. In other words, the main gate semiconductor layer 152m may have substantially the same planar shape as the main gate electrode 155m. However, the present disclosure is not limited thereto, and the main gate electrode 155m may also be located to cover at least a portion of the main gate semiconductor layer 152m.

The main gate semiconductor layer 152m may be located between the source electrode 170 and the drain electrode 190. The main gate semiconductor layer 152m may be spaced apart from the source electrode 170 and the drain electrode 190. The main gate semiconductor layer 152m may be located closer to the source electrode 170 than the drain electrode 190. That is, the separation distance between the main gate semiconductor layer 152m and the source electrode 170 may be smaller than the separation distance between the main gate semiconductor layer 152m and the drain electrode 190, but the present disclosure is not limited thereto.

In this example, the main gate semiconductor layer 152m may overlap the main gate electrode 155m in the third direction (Z direction). For example, the main gate semiconductor layer 152m may fully overlap the main gate electrode 155m in the third direction (Z direction). That is, a lateral surface of the main gate semiconductor layer 152m may be aligned with a lateral surface of the main gate electrode 155m. However, the present disclosure is not limited thereto, and the main gate semiconductor layer 152m may partially overlap the main gate electrode 155m.

The main gate semiconductor layer 152m may include one or more materials selected from group III-V materials, for example, nitrides including Al, Ga, In, B, or combinations thereof. The main gate semiconductor layer 152m may be AlₓIn_{y}Ga_{1-x-y}N (0≤x≤1, 0≤y≤1, x+y≤1). For example, the main gate semiconductor layer 152m may include AlN, GaN, InN, InGaN, AlGaN, AlInN, AlInGaN, or a combination thereof. The main gate semiconductor layer 152m may include a material having a different energy band gap from the barrier layer 136. For example, the main gate semiconductor layer 152m may include GaN, and the barrier layer 136 may include AlGaN. The main gate semiconductor layer 152m may be doped with a predetermined impurity. In this case, the impurities doped in the main gate semiconductor layer 152m may be p-type dopants that may provide holes. For example, the main gate semiconductor layer 152m may include GaN doped with p-type impurities. That is, the main gate semiconductor layer 152m may include a p-GaN layer. However, the present disclosure is not limited thereto, and the main gate semiconductor layer 152m may be a p-AlGaN layer.

A depletion region DPR may be formed within the main channel layer 132m by the main gate semiconductor layer 152m. The depletion region DPR may be located within the main drift region DTRm and may have a narrower width than the main drift region DTRm. As the main gate semiconductor layer 152m having a different energy band gap from the barrier layer 136 is located on the barrier layer 136, the energy band level of the portion of the barrier layer 136 overlapping the main gate semiconductor layer 152m may be increased. Accordingly, a depletion region DPR may be formed in a region of the main channel layer 132m overlapping the main gate semiconductor layer 152m. The depletion region DPR may be a region in the channel path of the main channel layer 132m where the two-dimensional electron gas 134 is not formed or has a lower electron concentration than the rest of the region. In other words, the depletion region DPR may be a region where the flow of the two-dimensional electron gas 134 is interrupted within the main drift region DTRm. As the depletion region DPR is generated, no current flows between the source electrode 170 and the drain electrode 190, and the channel path may be blocked. Accordingly, the semiconductor device may have a normally off characteristic.

That is, the semiconductor device may be a normally off high electron mobility transistor (HEMT). As illustrated in FIG. 4, in the normal state with no voltage applied to the main gate electrode 155m, the depletion region DPR is present and the semiconductor device may be in the off state. As illustrated in FIG. 5, when a voltage equal to or greater than a threshold voltage is applied to the main gate electrode 155m, the depletion region DPR disappears, and the two-dimensional electron gas 134 within the main drift region DTRm may continue without interruption. That is, the two-dimensional electron gas 134 may be formed throughout the channel path between the source electrode 170 and the drain electrode 190, and the semiconductor device may be in the on state. In summary, the semiconductor device may include semiconductor layers with different electrical polarization characteristics, and a semiconductor layer having relatively large polarizability may cause two-dimensional electron gas 134 in other heterojunction semiconductor layers. The two-dimensional electron gas 134 may be utilized as a channel between the source electrode 170 and the drain electrode 190, and the continuation or interruption of the flow of the two-dimensional electron gas 134 may be controlled by a bias voltage applied to the main gate electrode 155m. In the gate-off state, the flow of the two-dimensional electron gas 134 is blocked, so that no current may flow between the source electrode 170 and the drain electrode 190. In the gate-on state, as the flow of the two-dimensional electron gas 134 continues, current may flow between the source electrode 170 and the drain electrode 190.

The semiconductor device has been described above as being a normally off high electron mobility transistor, but the present disclosure is not limited thereto. For example, the semiconductor device may be a normally on high electron mobility transistor. In the case of a normally on high electron mobility transistor, the main gate semiconductor layer 152m may be omitted, and thus, the main gate electrode 155m may be located directly on the barrier layer 136. That is, the main gate electrode 155m may be in contact with the barrier layer 136. In the structure, the two-dimensional electron gas 134 may be utilized as a channel when no voltage is applied to the main gate electrode 155m, and current flow may occur between the source electrode 170 and the drain electrode 190. Additionally, when a negative voltage is applied to the main gate electrode 155m, the depletion region DPR may occur at the lower portion of the main gate electrode 155m where the flow of the two-dimensional electron gas 134 is interrupted.

The previously described seed layer 121, superlattice layer 124, high-resistance layer 126, main channel layer 132m, barrier layer 136, and main gate semiconductor layer 152m may be sequentially stacked on the substrate 110. At least one of the seed layer 121, the superlattice layer 124, the high-resistance layer 126, the main channel layer 132m, the barrier layer 136, and the main gate semiconductor layer 152m may be omitted in the semiconductor device. The seed layer 121, the superlattice layer 124, the high-resistance layer 126, the main channel layer 132m, the barrier layer 136, and the main gate semiconductor layer 152m may be made of the same base semiconductor material, and the material composition ratio of each layer may be different in consideration of the role of each layer, the performance required of the semiconductor device, and the like.

The semiconductor device may further include a first protective layer 140 located on the barrier layer 136.

The first protective layer 140 may be located on the barrier layer 136 and the main gate electrode 155m. The first protective layer 140 may cover the top surface and the lateral surface of the main gate electrode 155m and the lateral surface of the main gate semiconductor layer 152m. A lower surface of the first protective layer 140 may be in contact with the barrier layer 136 and the main gate electrode 155m. Accordingly, the barrier layer 136, the main gate semiconductor layer 152m, and the main gate electrode 155m may be protected by the first protective layer 140. However, the present disclosure is not limited thereto, and the main gate electrode 155m may penetrate the first protective layer 140 to be connected with the main gate semiconductor layer 152m, and the first protective layer 140 may not cover the top surface of the main gate electrode 155m. Alternatively, the lower surface of the first protective layer 140 may be in contact with the main gate semiconductor layer 152m. The first protective layer 140 may include an insulating material. For example, the first protective layer 140 may include an oxide, such as SiO₂ or Al₂O₃. As another example, the first protective layer 140 may include a nitride, such as SiN, or an oxynitride, such as SiON.

In FIGS. 4 and 5, the first protective layer 140 is illustrated as a single layer, but is not limited thereto, and the first protective layer 140 may include multiple layers including different materials.

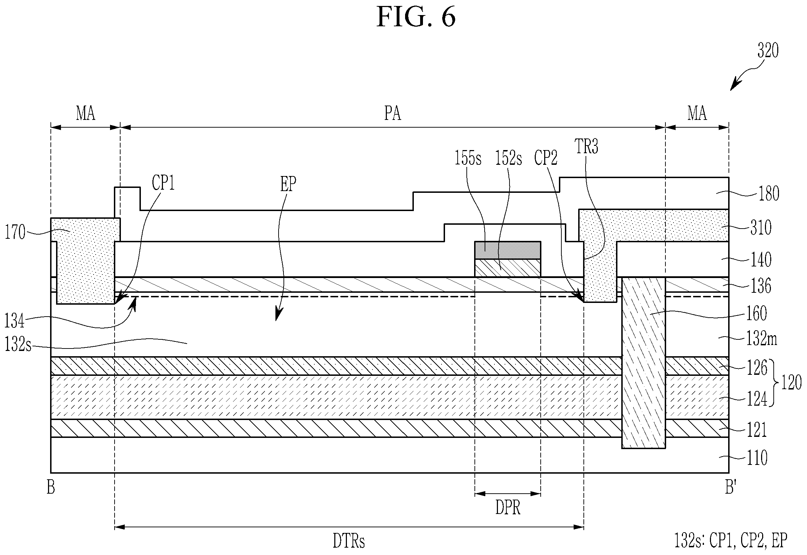

The source electrode 170 and the drain electrode 190 may be located on the main channel layer 132m. The source electrode 170 and the drain electrode 190 may be in direct contact with the main channel layer 132m and may be electrically connected to the main channel layer 132m. Additionally, the source electrode 170 may be electrically connected to the sub-channel layer 132s. For example, the source electrode 170 may be electrically connected to a first contact portion CP1 of the sub-channel layer 132s. This will be described in more detail later with reference to FIGS. 6 to 8.

The source electrode 170 and the drain electrode 190 may extend in the second direction (Y direction). The source electrode 170 and the drain electrode 190 may be spaced apart from each other, and the main gate electrode 155m and the main gate semiconductor layer 152m may be located between the source electrode 170 and the drain electrode 190. The main gate electrode 155m and the main gate semiconductor layer 152m may be spaced apart from the source electrode 170 and the drain electrode 190. For example, the source electrode 170 may be electrically connected to the main channel layer 132m on one side of the main gate electrode 155m, and the drain electrode 190 may be electrically connected to the main channel layer 132m on the other side of the main gate electrode 155m. The source electrode 170 and the drain electrode 190 may be located on the outer side of the main drift region DTRm of the main channel layer 132m. A boundary between the source electrode 170 and the main channel layer 132 m may be one edge of the main drift region DTRm. Similarly, the boundary between the drain electrode 190 and the main channel layer 132m may be the other edge of the main drift region DTRm. In this example, the drain electrode 190 may refer to a portion of the drain electrode 190 located in the main device region MA.

However, the present disclosure is not limited thereto, and in some examples the main channel layer 132m may not be recessed, and the source electrode 170 and the drain electrode 190 may be located on the top surface of the main channel layer 132m. In this case, the bottom surfaces of the source electrode 170 and the drain electrode 190 may be in contact with the top surface of the main channel layer 132m. The portion of the main channel layer 132m that is in contact with the source electrode 170 and the drain electrode 190 may be doped at a high concentration. In this case, carriers passing through the two-dimensional electron gas 134 may pass through the portion of the main channel layer 132m that is doped at a high concentration, that is, the upper portion of the two-dimensional electron gas 134, and delivered to the source electrode 170 and the drain electrode 190. The source electrode 170 and the drain electrode 190 may not be in direct contact with the two-dimensional electron gas 134 in a horizontal direction. Here, a horizontal direction may mean a direction parallel to the top surface of the main channel layer 132m or the barrier layer 136.

Specifically, trenches penetrating the first protective layer 140 and the barrier layer 136 and recessing the top surface of the main channel layer 132m may be spaced apart from each other on opposite sides of the main gate electrode 155m. The source electrode 170 and the drain electrode 190 may be respectively located within the trenches located on opposite sides of the main gate electrode 155m. The source electrode 170 and the drain electrode 190 may be formed to be filled within the trenches. Within the trench, the source electrode 170 and the drain electrode 190 may be in contact with the main channel layer 132m and the barrier layer 136. The main channel layer 132m may form the bottom surface and the lateral wall of the trench, and the barrier layer 136 may form the lateral wall of the trench. Thus, the source electrode 170 and the drain electrode 190 may be in contact with the top surface and the lateral surface of the main channel layer 132m. Further, the source electrode 170 and the drain electrode 190 may be in contact with the lateral surface of the barrier layer 136. That is, the source electrode 170 and the drain electrode 190 may cover the lateral surfaces of the main channel layer 132m and the barrier layer 136.

In this example, the source electrode 170 and the drain electrode 190 may cover at least a portion of the lateral surface of the first protective layer 140. For example, the source electrode 170 and the drain electrode 190 may cover the lateral surface of the first protective layer 140. The top surfaces of the source electrode 170 and the drain electrode 190 may protrude above the top surface of the first protective layer 140. Further, at least one of the source electrode 170 and the drain electrode 190 may cover at least a portion of the top surface of the first protective layer 140. However, the present disclosure is not limited thereto, and the source electrode 170 and the drain electrode 190 may cover at least a portion of the lateral surface of the first protective layer 140 and may not cover the remaining portion of the lateral surface of the first protective layer 140. In this case, the remaining portion of the first protective layer 140 may be located on the top surface of the source electrode 170 and the drain electrode 190.

The source electrode 170 and the drain electrode 190 may include a conductive material. For example, the source electrode 170 and the drain electrode 190 may include a metal, a metal alloy, a conductive metal nitride, a metal silicide, a doped semiconductor material, a conductive metal oxide, or a conductive metal nitric oxide. For example, the source electrode 170 and the drain electrode 190 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbon nitride (TiAlC-N), titanium aluminum carbide (TiAlC), titanium carbide (TiC), tantalum carbon nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The source electrode 170 and the drain electrode 190 may be a single layer or multiple layers. The source electrode 170 and the drain electrode 190 may be in ohmic contact with the main channel layer 132m. Within the main channel layer 132m, the regions in contact with the source electrode 170 and the drain electrode 190 may be doped at relatively high concentrations compared to other regions.

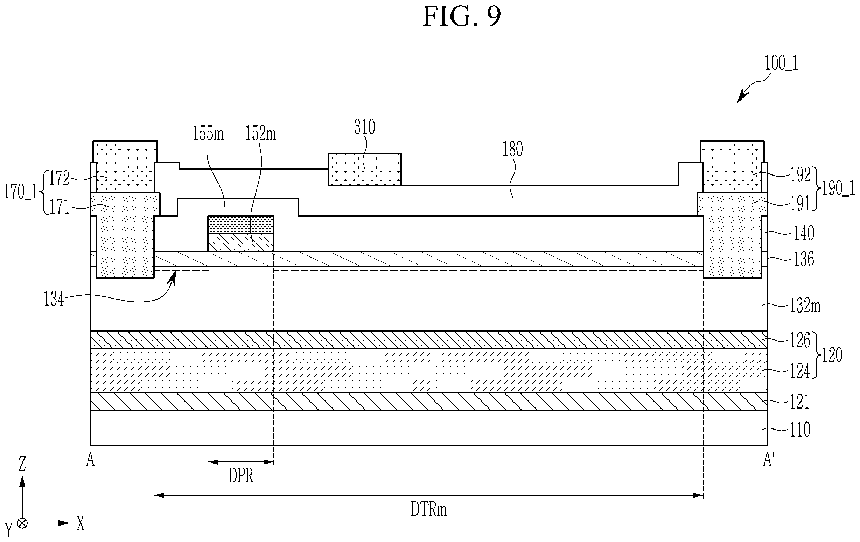

FIGS. 4 and 5 illustrate the semiconductor device as including a pair of source electrode 170 and drain electrode 190, but the number of source electrodes 170 and drain electrodes 190 is not limited thereto. For example, the source electrode 170 may include a plurality of source electrodes stacked sequentially in the third direction (Z-direction) on the main channel layer 132 m, and the drain electrode 190 may include a plurality of drain electrodes stacked sequentially in the third direction (Z-direction) on the main channel layer 132 m. These will be described hereinafter with reference to FIG. 9.

The field dispersion layer 310 may be located between the main gate electrode 155m and the drain electrode 190. The field dispersion layer 310 may be located between the source electrode 170 and the drain electrode 190. The field dispersion layer 310 may be located on the first protective layer 140. The field dispersion layer 310 may overlap the main channel layer 132m in the third direction (Z direction). Further, the field dispersion layer 310 may overlap at least a portion of a separation structure 160 and the sub-channel layer 132s in the third direction (Z direction), which will be described later, but is not limited thereto. The field dispersion layer 310 may not overlap, e.g., is spaced apart from, the main gate electrode 155m, the source electrode 170, and the drain electrode 190 in the third direction (z-direction), but is not limited thereto.

The field dispersion layer 310 may be spaced apart from the source electrode 170. The field dispersion layer 310 may extend, e.g., is elongated, in the same direction as the source electrode 170. For example, the field dispersion layer 310 and the source electrode 170 may extend in the second direction (Y direction), but are not limited thereto. The field dispersion layer 310 may be electrically connected to the sub-channel layer 132s of the sub-transistor 320, which will be described later. For example, the field dispersion layer 310 may be directly connected to a second contact portion CP2 of the sub-channel layer 132s, which will be described later. Accordingly, the field dispersion layer 310 may be electrically connected to the source electrode 170 via the sub-channel layer 132s, which will be described later. Specifically, when the sub-transistor 320 is turned on, the field dispersion layer 310 may be electrically connected to the source electrode 170. When the sub-transistor 320 is turned off, the field dispersion layer 310 may be electrically isolated from the source electrode 170 and may be floated. These will be described hereinafter with reference to FIGS. 6 to 8.

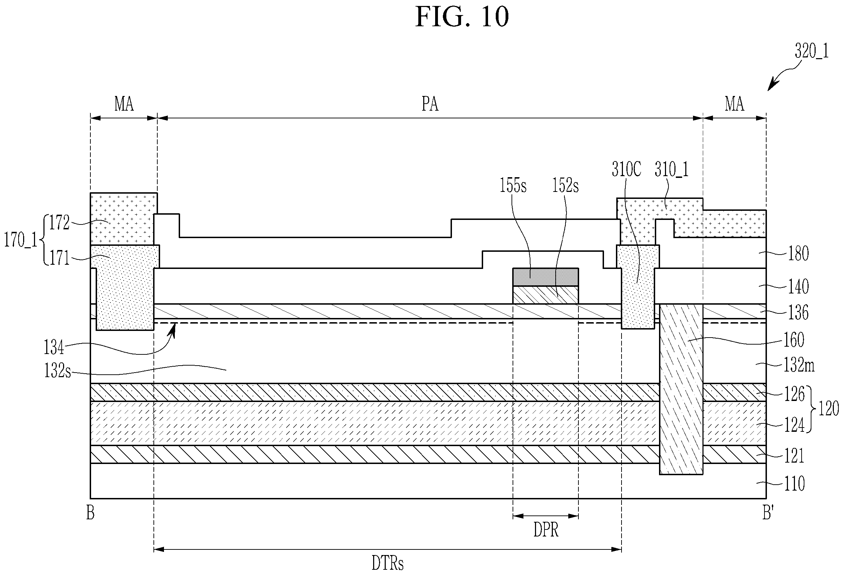

In some implementations, the field dispersion layer 310 may be connected to the sub-channel layer 132s via a separate contact electrode. These will be described hereinafter with reference to FIG. 10.

The field dispersion layer 310 may include the same material as the source electrode 170. The field dispersion layer 310 may be located in the same layer as at least a portion of the source electrode 170. For example, the portion of the source electrode 170 that is located on the first protective layer 140 may be located in the same layer as the field dispersion layer 310. The field dispersion layer 310 may be formed simultaneously in the same process as the source electrode 170. However, the present disclosure is not limited thereto, and the field dispersion layer 310 may be located in a different layer than the source electrode 170 and may be formed in a different process.

The field dispersion layer 310 may serve to dissipate the electric field concentrated around the main gate electrode 155m. Specifically, in the gate-off state, a portion of the main channel layer 132m located between the main gate electrode 155m and the source electrode 170 and a portion of the main channel layer 132m located between the main gate electrode 155m and the drain electrode 190 may have a very high concentration of two-dimensional electron gas 134. In this case, an electric field may be concentrated on the main gate electrode 155m or the main gate semiconductor layer 152m. On the other hand, the main gate electrode 155m and the main gate semiconductor layer 152m are vulnerable to electric fields, which may increase the leakage current and decrease the breakdown voltage of the main transistor 100 when the electric field is concentrated. In this case, the electric field concentrated around the main gate electrode 155m or the main gate semiconductor layer 152m by the field dispersion layer 310 may be dissipated, so that the leakage current may be reduced, and the breakdown voltage may be increased. On the other hand, as described above, when the sub-transistor 320 is turned off, the field dispersion layer 310 is being floated, so that charges may accumulate within the field dispersion layer 310 by the electric field around the field dispersion layer 310. When the sub-transistor 320 is turned on, the field dispersion layer 310 is electrically connected to the source electrode 170 via the sub-transistor 320, such that the charge accumulated within the field dispersion layer 310 may be discharged.

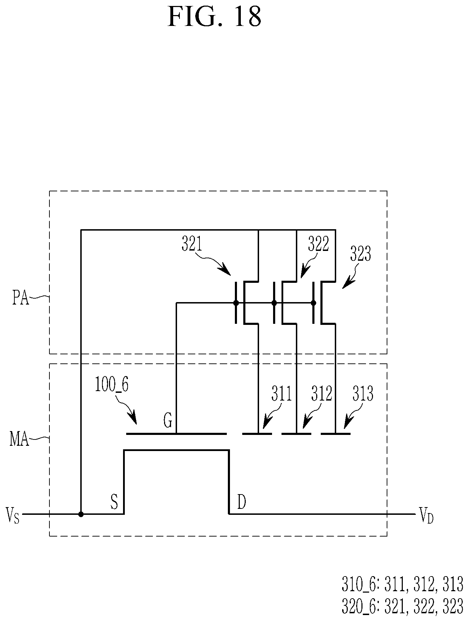

FIGS. 4 and 5 illustrate the semiconductor device as including one field dispersion layer 310, but the number of field dispersion layers 310 is not limited thereto. For example, the field dispersion layer 310 may include a plurality of field dispersion layers located on the first protective layer 140. As another example, a plurality of protective layers may be located on the first protective layer 140 and may include a plurality of field dispersion layers located on different protective layers. This will be described later with reference to FIG. 18.

The semiconductor device may further include a second protective layer 180 located on the field dispersion layer 310 and the first protective layer 140.

The second protective layer 180 may cover the top surface of the first protective layer 140, the top surface and the lateral surface of the field dispersion layer 310, and the top surfaces of the source electrode 170 and the drain electrode 190. The second protective layer 180 may include trenches 141 and 143 that expose the source electrode 170 and the drain electrode 190. The source electrode 170 and the drain electrode 190 may be electrically connected to wires by the trenches 141 and 143, respectively. The second protective layer 180 may include an insulating material. The second protective layer 180 may include the same material as the first protective layer 140, but is not limited thereto. For example, the second protective layer 180 may include an oxide, such as SiO₂ or Al₂O₃. As another example, the second protective layer 180 may include a nitride, such as SiN, or an oxynitride, such as SiON.

Hereinafter, a peripheral circuit element of the semiconductor device will be described with reference to FIG. 3 and FIGS. 6 to 8.

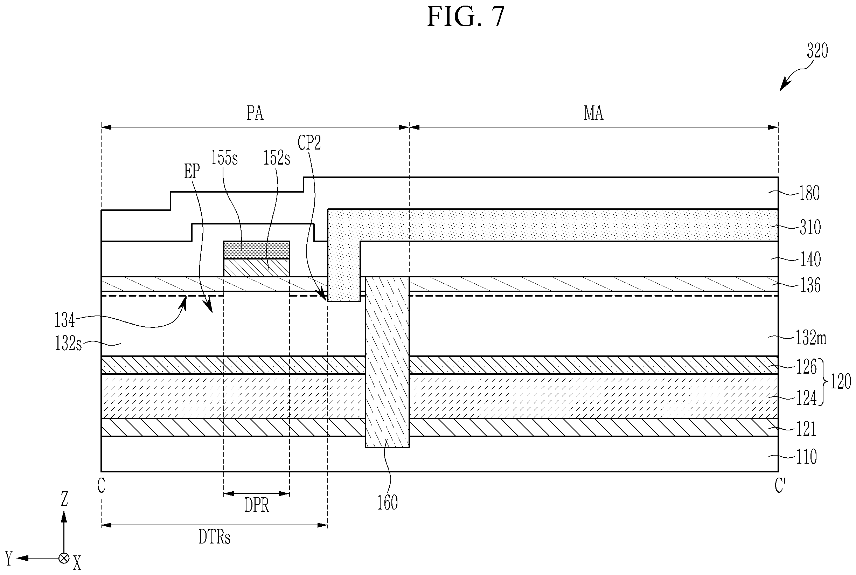

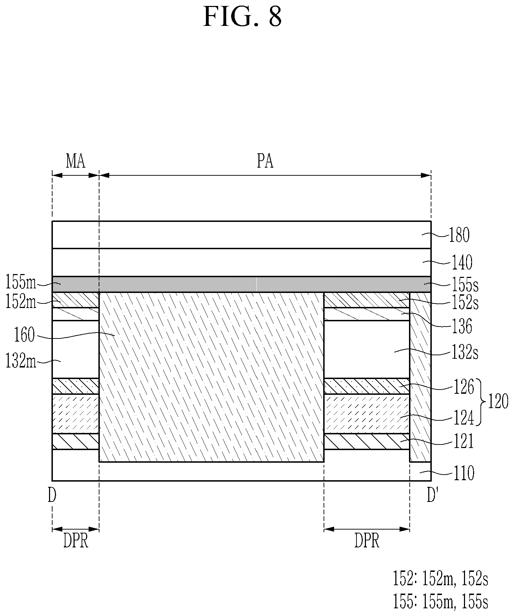

FIG. 6 is a cross-sectional view taken along line B-B' of FIG. 3. FIG. 7 is a cross-sectional view taken along line C-C' of FIG. 3. FIG. 8 is a cross-sectional view taken along line D-D' of FIG. 3.

Referring to FIG. 3 and FIGS. 6 to 8, the semiconductor device includes the sub-transistor 320 connected to one end of the main transistor 100.

The sub-transistor 320 of the semiconductor device may include a sub-drift region DTRs with two-dimensional electron gas 134, with the sub-channel layer 132s connected with the source electrode 170 and the field dispersion layer 310. The sub-gate electrode 155s is located above the sub-channel layer 132s and connected with the main gate electrode 155m. In this example, the sub-channel layer 132s may configure a channel of the sub-transistor 320, the field dispersion layer 310 may configure the first electrode (Da in FIG. 1) of the sub-transistor 320, the source electrode 170 may configure the second electrode (Sa in FIG. 1) of the sub-transistor 320, and the sub-gate electrode 155s may configure the gate electrode (Ga in FIG. 1) of the sub-transistor 320.

The sub-channel layer 132s may be located above the substrate 110. The sub-channel layer 132s is a layer that forms a channel between the source electrode 170 and the field dispersion layer 310, and two dimensional electron gas (2DEG) 134 may be located inside the sub-channel layer 132s. The two-dimensional electron gas 134 may be generated at the interface between the sub-channel layer 132s and the barrier layer 136 in the semiconductor device. For example, the two-dimensional electron gas 134 may be generated in a portion inside the sub-channel layer 132s adjacent to the barrier layer 136. In this example, the sub-channel layer 132s may refer to a portion of channel layer 132 that is located in the peripheral circuit region PA and configures the channel of the sub-transistor 320.

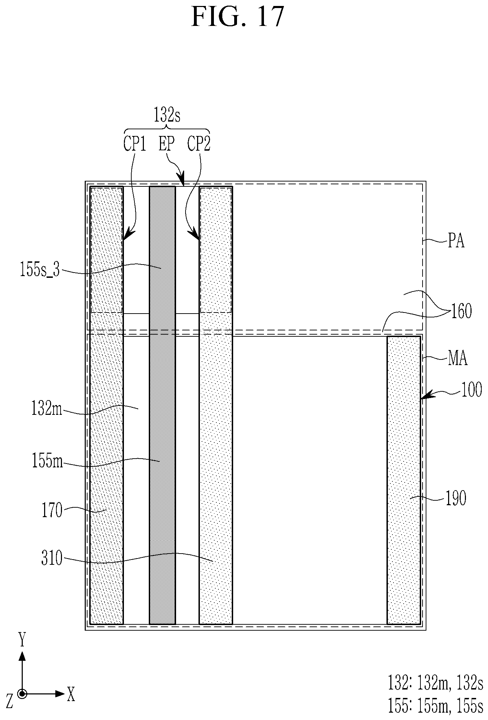

In this example, the sub-channel layer 132s may be located on one side of the main channel layer 132m. For example, the sub-channel layer 132s may be located on one side along the second direction (Y direction) of the main channel layer 132m, but is not limited thereto. One end of the sub-channel layer 132s may be connected to the source electrode 170 and the other end of the sub-channel layer 132s may be connected to the field dispersion layer 310. The sub-channel layer 132s may have various shapes in a planar view. For example, the sub-channel layer 132s may include a portion extending in the second direction (Y direction) to be connected with the source electrode 170, a portion extending in the second direction (Y direction) to be connected with the field dispersion layer 310, and a portion extending in the first direction (X direction). However, the present disclosure is not limited thereto, and the shape of the sub-channel layer 132s may be varied within the extent of the connection between the source electrode 170 and the field dispersion layer 310. These will be described hereinafter with reference to FIG. 17.

In this example, the sub-channel layer 132s may be integrally formed by the same process as the main channel layer 132m of the main transistor 100. The sub-channel layer 132s may be located on the same layer as the main channel layer 132m. A lower surface of the sub-channel layer 132s may be located at the same level as a lower surface of the main channel layer 132m, and a top surface of the sub-channel layer 132s may be located at the same level as a top surface of the main channel layer 132m. In other words, the distance between lower surface of the sub-channel layer 132s and the top surface of the substrate 110 may be the same as the distance between the lower surface of the main channel layer 132m and the top surface of the substrate 110. Further, the top surface of the sub-channel layer 132s may be located at the same distance from the top surface of the main channel layer 132m and the top surface of the substrate 110. The thickness along the third direction (Z direction) of the sub-channel layer 132s may be substantially the same as the thickness along the third direction (Z direction) of the main channel layer 132m, but is not limited thereto. In this case, the sub-channel layer 132s and the main channel layer 132m may be separated by a separation structure 160, which will be described later.

In this example, the sub-channel layer 132s may include the same material as the main channel layer 132m. In one example, the sub-channel layer 132s may include one or more materials selected from group III-V materials, for example, nitrides including Al, Ga, In, B, or combinations thereof.

The sub-channel layer 132s of the semiconductor device may include the first contact portion CP1 connected with the source electrode 170, the second contact portion CP2 connected with the field dispersion layer 310, and an extension portion EP connecting the first contact portion CP1 and the second contact portion CP2.

The first contact portion CP1 may be connected to the source electrode 170. The first contact portion CP1 may be in contact with the source electrode 170. For example, as illustrated in FIG. 6, the source electrode 170 may penetrate the first protective layer 140 and the barrier layer 136 to be electrically connected with the first contact portion CP1. In this case, the source electrode 170 may be located within the recessed space of the first contact portion CP1. The source electrode 170 may penetrate the barrier layer 136 to be in contact with the lateral surface of the sub-channel layer 132s. As another example, the first contact portion CP1 may not be recessed, and the source electrode 170 may be located on the top surface of the first contact portion CP1. The boundary between the source electrode 170 and the sub-channel layer 132s may be one edge of the sub-drift region DTRs. The first contact portion CP1 may refer to the portion of the sub-channel layer 132s to which the source electrode 170 is connected.

The second contact portion CP2 may be connected to the field dispersion layer 310. The second contact portion CP2 may be in contact with the field dispersion layer 310. For example, as illustrated in FIGS. 6 and 7, the field dispersion layer 310 may be electrically connected to the second contact portion CP2 through the first protective layer 140 and the barrier layer 136. In this case, the field dispersion layer 310 may be located within the recessed space of the second contact portion CP2. The field dispersion layer 310 may penetrate the barrier layer 136 to be in contact with the lateral surface of the sub-channel layer 132s. However, the present disclosure is not limited thereto, and for example, the second contact portion CP2 may, in some cases, not be recessed and the field dispersion layer 310 may be located on the top surface of the second contact portion CP2. The boundary between the field dispersion layer 310 and the sub-channel layer 132s may be the other edge of the sub-drift region DTRs. The second contact portion CP2 may refer to the portion of the sub-channel layer 132s to which the field dispersion layer 310 is connected. Accordingly, the field dispersion layer 310 may overlap the main channel layer 132m in the third direction (Z direction), and may overlap at least a portion of the sub-channel layer 132s in the third direction (Z direction).

The extension portion EP may be located between the first contact portion CP1 and the second contact portion CP2. The extension portion EP may connect the first contact portion CP1 and the second contact portion CP2. The extension portion EP may have various shapes in a planar view. For example, as illustrated in FIG. 3, the extension portion EP may include a portion extending in the second direction (Y direction) to be connected with the first contact portion CP1, a portion extending in the second direction (Y direction) to be connected with the field dispersion layer 310, and a portion extending in the first direction (X direction). However, the present disclosure is not limited thereto, and the shape of the extension portion EP may be varied within the extent of the connection between the source electrode 170 and the field dispersion layer 310.

In this example, the seed layer 121 and the buffer layer 120 may be located between the substrate 110 and the sub-channel layer 132s. The substrate 110, the seed layer 121, and the buffer layer 120 are layers that are required to form the sub-channel layer 132s and may be omitted in some cases. In this example, the substrate 110, the seed layer 121, and the buffer layer 120 located in the peripheral circuit region PA may be integrally formed by the same process as the substrate 110, the seed layer 121, and the buffer layer 120 located in the main device region MA, respectively.

The barrier layer 136 of the semiconductor device may be located further above the sub-channel layer 132s. That is, the barrier layer 136 may extend further above the sub-channel layer 132s. The barrier layer 136 may be located directly on the sub-channel layer 132s. However, the present disclosure is not limited thereto, and any other predetermined layer may be further located between the sub-channel layer 132s and the barrier layer 136. The region of the sub-channel layer 132s that overlaps the barrier layer 136 may be a drift region. Specifically, as the barrier layer 136 differs from the sub-channel layer 132s in at least one of polarization characteristics, energy band gap, and lattice constant, the two-dimensional electron gas 134 may be induced in the sub-channel layer 132s that has relatively low electrical polarizability by the barrier layer 136.

As illustrated in FIGS. 6 and 7, in the peripheral circuit region PA, the sub-channel layer 132s may include the sub-drift region DTRs between the field dispersion layer 310 and the source electrode 170. That is, the sub-drift region DTRs may refer to a region of the sub-channel layer 132s from one side of the sub-channel layer 132s that is in contact with the source electrode 170 to the field dispersion layer 310. The sub-drift region DTRs may refer to regions of the sub-channel layer 132s that overlap the barrier layer 136 between the field dispersion layer 310 and the source electrode 170. For example, the boundary where the source electrode 170 and the sub-channel layer 132s meet may be one edge of the sub-drift region DTRs, and the boundary where the field dispersion layer 310 and the sub-channel layer 132s meet may be the other edge of the sub-drift region DTRs. In other words, the sub-drift region DTRs may refer to a region of carrier migration between one side of the sub-channel layer 132s that is in contact with the source electrode 170 and the field dispersion layer 310 within the peripheral circuit region PA.

The sub-gate electrode 155s may be located in the peripheral circuit region PA. The sub-gate electrode 155s may be located above the extension portion EP of the sub-channel layer 132s. For example, the sub-gate electrode 155s may overlap the extension portion EP of the sub-channel layer 132s in the third direction (Z-direction). That is, the sub-gate electrode 155s may overlap a portion of the sub-drift region DTRs of the sub-channel layer 132s in the third direction (Z-direction). In this example, the sub-gate electrode 155s may refer to a portion of the gate electrode 155 located in the peripheral circuit region PA. Accordingly, the gate electrode 155 may overlap the extension portion EP of the sub-channel layer 132s in the third direction (Z direction).

The sub-gate electrode 155s may be located above the barrier layer 136. The sub-gate electrode 155s may be electrically connected to the main gate electrode 155m.

The sub-gate electrode 155s may be located between the field dispersion layer 310 and the source electrode 170 on the sub-channel layer 132s. That is, the sub-gate electrode 155s may be located between the first contact portion CP1 of the sub-channel layer 132s to which the source electrode 170 is connected and the second contact portion CP2 to which the field dispersion layer 310 is connected. The sub-gate electrode 155s may be spaced apart from the field dispersion layer 310 and the source electrode 170. The sub-gate electrode 155s may be located closer to the field dispersion layer 310 than the source electrode 170, but is not limited thereto. That is, the separation distance between the sub-gate electrode 155s and the field dispersion layer 310 may be smaller than the separation distance between the sub-gate electrode 155s and the source electrode 170, but the present disclosure is not limited thereto.

In this example, the sub-gate electrode 155s may be integrally formed with the main gate electrode 155m of the main transistor 100. That is, the sub-gate electrode 155s may be integrally formed by the same process as the main gate electrode 155m of the main transistor 100. For example, as illustrated in FIG. 8, the sub-gate electrode 155s may be located on the same layer as the main gate electrode 155m. A lower surface of the sub-gate electrode 155s may be located at the same level as a lower surface of the main gate electrode 155m, and a top surface of the sub-gate electrode 155s may be located at the same level as a top surface of the main gate electrode 155m. In other words, the distance between the top surface of the substrate 110 and the lower surface of the sub-gate electrode 155s may be the same distance as between the top surface of the substrate 110 and the lower surface of the main gate electrode 155m. The thickness along the third direction (Z direction) of the sub-gate electrode 155s may be substantially the same as the thickness along the third direction (Z direction) of the main gate electrode 155m, but is not limited thereto.

However, the present disclosure is not limited thereto, and in some implementations, the sub-gate electrode 155s may, in some cases, not be integrally formed with the main gate electrode 155m. However, even in this case, the sub-gate electrode 155s may be electrically connected to the main gate electrode 155m via upper wires or the like.

The sub-gate electrode 155s may include a conductive material. The sub-gate electrode 155s may include the same material as the main gate electrode 155m. However, the present disclosure is not limited thereto, and the sub-gate electrode 155s may include a different material from the main gate electrode 155m.

In some implementations, a hard mask layer located on the sub-gate electrode 155s may be further included. The hard mask layer may be a hard mask that was used to pattern the gate electrode material layer and/or the gate semiconductor layer during the process of forming the sub-gate electrode 155s. However, the hard mask layer may be removed during etching of the gate electrode material layer and/or the gate semiconductor layer based on etching conditions or post-etch cleaning conditions. In one example, the hard mask layer may include a silicon oxide, a silicon nitride, a silicon nitric oxide, or a combination thereof.

The sub-gate semiconductor layer 152s may be located between the barrier layer 136 and the sub-gate electrode 155s. The sub-gate semiconductor layer 152s may overlap the sub-gate electrode 155s in the third direction (Z direction). In one example, the sub-gate semiconductor layer 152s may fully overlap the sub-gate electrode 155s in the third direction (Z-direction), but is not limited thereto. Further, the sub-gate semiconductor layer 152s may overlap the separation structure 160 in the third direction (Z-direction), but is not limited thereto. The sub-gate electrode 155s may be in Schottky contact or ohmic contact with the sub-gate semiconductor layer 152s. The structural shape of the sub-gate semiconductor layer 152s and the sub-gate electrode 155s may be substantially the same as the structural shape of the main gate semiconductor layer 152m and the main gate electrode 155m. However, the present disclosure is not limited thereto. In some implementations, the sub-gate semiconductor layer 152s may not be located between the barrier layer 136 and the sub-gate electrode 155s. In this case, the lower surface of the sub-gate electrode 155s may be in contact with the barrier layer 136.

In this example, the sub-gate semiconductor layer 152s may be located between the field dispersion layer 310 and the source electrode 170 above the sub-channel layer 132s. The sub-gate semiconductor layer 152s may be located above the extension portion EP of the sub-channel layer 132s. That is, the sub-gate semiconductor layer 152s may be located between the first contact portion CP1 of the sub-channel layer 132s to which the source electrode 170 is connected and the second contact portion CP2 to which the field dispersion layer 310 is connected. The sub-gate semiconductor layer 152s may be spaced apart from the field dispersion layer 310 and the source electrode 170.

In this example, the sub-gate semiconductor layer 152s may be integrally formed with the main gate semiconductor layer 152m of the main transistor 100. That is, the sub-gate semiconductor layer 152s may be integrally formed with the main gate semiconductor layer 152m of the main transistor 100 by the same process. For example, as illustrated in FIG. 8, the sub-gate semiconductor layer 152s may be located on the same layer as the main gate semiconductor layer 152m. A lower surface of the sub-gate semiconductor layer 152s may be located at the same level as a lower surface of the main gate semiconductor layer 152m, and a top surface of the sub-gate semiconductor layer 152s may be located at the same level as a top surface of the main gate semiconductor layer 152m. In other words, the distance between the top surface of the substrate 110 and lower surface of the sub-gate semiconductor layer 152s may be the same distance as between the top surface of the substrate 110 and the lower surface of the main gate semiconductor layer 152m. The thickness along the third direction (Z direction) of the sub-gate semiconductor layer 152s may be substantially the same as the thickness along the third direction (Z direction) of the main gate semiconductor layer 152m, but is not limited thereto.

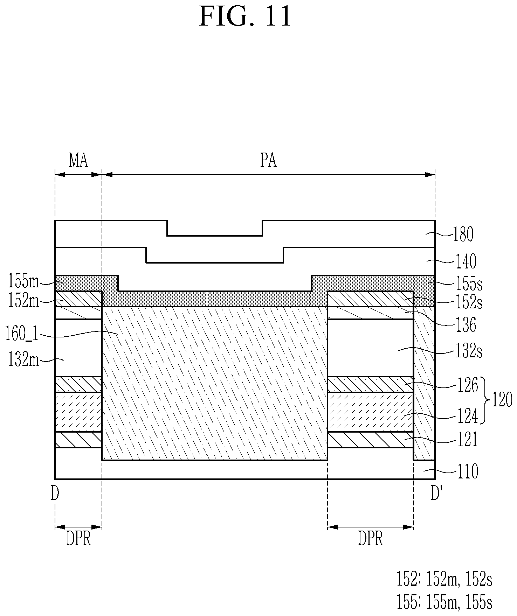

In some implementations, the sub-gate semiconductor layer 152s may be spaced apart from the main gate semiconductor layer 152m. These will be described hereinafter with reference to FIG. 11.

The sub-gate semiconductor layer 152s may include a conductive material. The sub-gate semiconductor layer 152s may include the same material as the main gate semiconductor layer 152m. However, the present disclosure is not limited thereto, and the sub-gate semiconductor layer 152s may include a different material from the main gate semiconductor layer 152m.

The depletion region DPR may be formed in the sub-channel layer 132s by the sub-gate semiconductor layer 152s. The depletion regions DPR may be located within the sub-drift region DTRs. In other words, the depletion region DPR may be a region where the flow of the two-dimensional electron gas 134 is interrupted within the sub-drift region DTRs. As the depletion region DPR is generated, no current flows between the field dispersion layer 310 and the source electrode 170, and the channel path may be blocked.

In summary, the sub-transistor 320 of the semiconductor device may include the sub-channel layer 132s, the sub-gate electrode 155s, the source electrode 170, and the field dispersion layer 310. Within the sub-channel layer 132s, the sub-drift region DTRs and depletion regions DPR may be formed. In response to a signal from the sub-gate electrode 155s, the sub-transistor 320 may be turned on, thereby controlling the current flowing between the field dispersion layer 310 and the source electrode 170.

Specifically, the sub-gate electrode 155s may be electrically connected to the main gate electrode 155m. Accordingly, when a turn-off signal is applied to the main gate electrode 155m, a turn-off signal may also be applied to the sub-gate electrode 155s, and the sub-transistor 320 may be turned off. Accordingly, the field dispersion layer 310 configuring the first electrode (Da in FIG. 1) of the sub-transistor 320 may be electrically isolated from the source electrode 170 configuring the second electrode (Sa in FIG. 1) of the sub-transistor 320. That is, the field dispersion layer 310 may be floated, and the field dispersion layer 310 may play a role to dissipate the electric field concentrated around the main gate electrode 155m of the main transistor 100. At this time, charges may accumulate within the field dispersion layer 310 by a voltage-induced electric field, leakage current, or the like. When charges accumulate in the field dispersion layer 310, the voltage of the drain electrode 190 and the main gate electrode 155m may become unstable.

On the other hand, when a turn-on signal is applied to the main gate electrode 155m, a turn-on signal may be applied to the sub-gate electrode 155s together, and the sub-transistor 320 may be turned on. Accordingly, current may flow from the field dispersion layer 310 to the source electrode 170, and the charge accumulated within the field dispersion layer 310 may be discharged through the source electrode 170. Thus, the influence of the accumulated charge in the field dispersion layer 310 may be eliminated, and the field dispersion layer 310 may effectively dissipate the electric field concentrated around the main gate electrode 155m of the main transistor 100, and the reliability of the semiconductor device may be improved.

The first protective layer 140 and the second protective layer 180 of the semiconductor device may be further located in the peripheral circuit region PA. That is, the first protective layer 140 and the second protective layer 180 may extend further above the sub-channel layer 132s and the separation structure 160, which will be described later. Accordingly, the first protective layer 140 may cover the barrier layer 136 and the sub-gate electrode 155s located above the sub-channel layer 132s, and the second protective layer 180 may cover the first protective layer 140.

The semiconductor device may further include the separation structure 160 located between the sub-transistor 320 and the main transistor 100.

In this example, the sub-transistor 320 may be separated from the main transistor 100 by the separation structure 160. For example, as illustrated in FIG. 3, the main transistor 100 and the sub-transistor 320 may be spaced apart in the second direction (Y direction) by the separation structure 160, but the relative locations are not limited thereto.

In this example, the separation structure 160 may penetrate the barrier layer 136. For example, as illustrated in FIGS. 6 to 8, the separation structure 160 may penetrate the barrier layer 136, the channel layer 132, the seed layer 121, and the buffer layer 120 to recess at least a portion of the substrate 110. The separation structure 160 may be located between the main gate semiconductor layer 152m and the sub-gate semiconductor layer 152s, but is not limited thereto. Accordingly, the sub-drift region DTRs of the sub-channel layer 132s may be electrically isolated from the main drift region DTRm of the main channel layer 132m. As another example, the present disclosure is not limited thereto, and the separation structure 160 may penetrate the barrier layer 136 and the channel layer 132 and recess at least a portion of the buffer layer 120. In this example, the separation structure 160 may be formed by forming the barrier layer 136 on top of the main channel layer 132m and the sub-channel layer 132s, and performing an ion implant process within the barrier layer 136 that is located between the main transistor 100 and the sub-transistor 320. For example, no or very little two-dimensional electron gas may be formed in the region of the channel layer 132 that overlaps the region where the ion implantation process was performed in the barrier layer 136 in the third direction (Z direction). In this case, the ion implanted region of the barrier layer 136 and the region of the channel layer 132 corresponding to the ion implanted region may correspond to the separation structure 160. As another example, gate semiconductor layers 152m and 152s may be formed on top of barrier layer 136, and after performing the ion implantation process on top of gate semiconductor layers 152m and 152s, the gate semiconductor layers 152m and 152s may be patterned. Accordingly, the exposed barrier layer 136, the channel layer 132, and the ion implanted region of the buffer layer 120 may correspond to the separation structure 160. The region of the channel layer 132 where the ion implantation process was performed may have no or very little two-dimensional electron gas formed. The material used in the ion implantation process may be argon (Ar) ions. However, the present disclosure is not limited thereto, and the separation structure 160 may also be formed by forming the barrier layer 136 on the main channel layer 132m and the sub-channel layer 132s, forming a trench through the barrier layer 136, and then filling the trench with an insulating material. The insulating material configuring the separation structure 160 may include the same material as the first protective layer 140 and/or the second protective layer 180. For example, the insulating material configuring the separation structure 160 may include an oxide, such as SiO₂ or Al₂O₃. As another example, the insulating material configuring the separation structure 160 may include a nitride, such as SiN, or an oxynitride, such as SiON. However, the present disclosure is not limited thereto, and the insulating material configuring the separation structure 160 may also include a different material from the first protective layer 140. In this case, at least a portion of the main channel layer 132m and/or the sub-channel layer 132s may be recessed together.

Hereinafter, an example of a resistive element of a semiconductor device will be described with reference to FIGS. 9 to 17.

FIG. 9 to FIG. 17 are cross-sectional and top plan views illustrating semiconductor devices.

FIGS. 9 to 17 illustrate various modified examples of the semiconductor device illustrated in FIGS. 1 to 8. Since some parts of the examples illustrated in FIGS. 9 to 17 are substantially the same as those of the examples illustrated in FIGS. 1 to 8, a description thereof will be omitted, and the differences will be mainly described. Also, the same reference numerals are used for components that are identical to the preceding examples.

Referring to FIGS. 9 and 10, the semiconductor device includes the plurality of the source electrodes 170_1 and the drain electrodes 190_1.

Referring to FIG. 9, the source electrodes 170_1 of the semiconductor device include a first source electrode 171 and a second source electrode 172 stacked sequentially in the third direction (Z direction) on the main channel layer 132m, and the drain electrodes 190_1 include a first drain electrode 191 and a second drain electrode 192 stacked sequentially in the third direction (Z direction) on the main channel layer 132m. The first source electrode 171 and the first drain electrode 191 may penetrate the first protective layer 140 and the barrier layer 136 to be connected with the main channel layer 132m. Each of the second source electrode 172 and the second drain electrode 192 may penetrate the second protective layer 180 and be connected to the first source electrode 171 and the first drain electrode 191. Each of the first source electrode 171 and the first drain electrode 191 may include the same material as the second source electrode 172 and the second drain electrode 192, but may also include different materials.

Additionally, the field dispersion layer 310_1 of the semiconductor device may be located on the second protective layer 180. The field dispersion layer 310_1 may be located on the second protective layer 180 and spaced apart from the source electrode 170_1 and the drain electrode 190_1. The field dispersion layer 310_1 may include the same material as the second source electrode 172. The field dispersion layer 310_1 may be formed by the same process as the second source electrode 172 and may be located in the same layer as at least a portion of the second source electrode 172. However, the present disclosure is not limited thereto, and the field dispersion layer 310_1 may be located in a different layer from the second source electrode 172, and may be formed by a different process.

Referring further to FIG. 10, the semiconductor device may further include a contact electrode 310C located between the field dispersion layer 310_1 and the sub-channel layer 132s.

The contact electrode 310C may penetrate the first protective layer 140 and the barrier layer 136 to be electrically connected with the sub-channel layer 132s. The contact electrode 310C may be located within the recessed space of the sub-channel layer 132s. Accordingly, the contact electrode 310C may be in contact with a portion of the lateral surface of the sub-channel layer 132s, but is not limited thereto. The contact electrode 310C may include the same material as the first source electrode 171 and the first drain electrode 191. The contact electrode 310C may be formed together in the same process as the first source electrode 171 and the first drain electrode 191. However, the present disclosure is not limited thereto, and the contact electrode 310C may include a different material from the first source electrode 171 and the first drain electrode 191. The contact electrode 310C may be formed in a different process from the first source electrode 171 and the first drain electrode 191.

In some implementations, the field dispersion layer 310_1 may penetrate the second protective layer 180 and be connected to the contact electrode 310C. The field dispersion layer 310_1 may overlap the contact electrode 310C in the third direction (Z direction). The field dispersion layer 310_1 may be electrically connected to the sub-channel layer 132s via the contact electrode 310C.

Referring to FIG. 11, the sub-gate semiconductor layer 152s of the semiconductor device according to some example embodiments may be spaced apart from the main gate semiconductor layer 152m.

In some implementations, the sub-gate semiconductor layer 152s may be located above the sub-channel layer 132s, and the main gate semiconductor layer 152m may be located above the main channel layer 132m. In this case, the sub-gate semiconductor layer 152s may not be located on the separation structure 160_1 located between the main channel layer 132m and the sub-channel layer 132s. The sub-gate semiconductor layer 152s may not overlap the separation structure 160_1 in the third direction (Z direction). That is, the sub-gate semiconductor layer 152s may be located only above the sub-channel layer 132s, but is not limited thereto. In this case, the sub-gate electrode 155s may cover the lateral surface and the top surface of the sub-gate semiconductor layer 152s, and the main gate electrode 155m may cover the lateral surface and the top surface of the main gate semiconductor layer 152m, but the present disclosure is not limited thereto. As another example, the sub-gate electrode 155s may cover only the top surface of the sub-gate semiconductor layer 152s, the main gate electrode 155m may cover only the top surface of the main gate semiconductor layer 152m, and the sub-gate electrode 155s may be electrically connected to the main gate electrode 155m via separate top wires or the like.

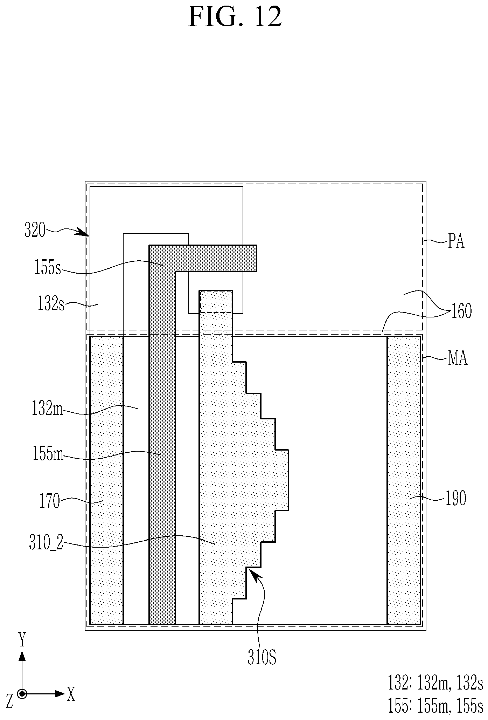

Referring now to FIGS. 12 to 14, the field dispersion layer 310 of the semiconductor device may have various shapes.

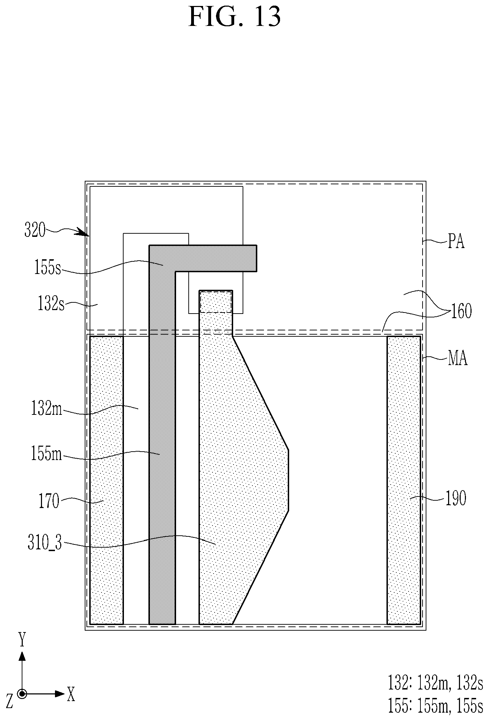

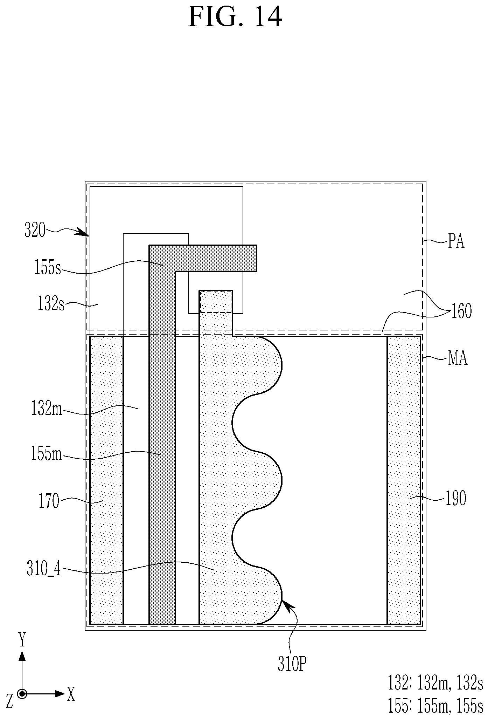

In some implementations, the field dispersion layer 310 may have a shape that protrudes toward the drain electrode 190. For example, as illustrated in FIG. 12, the field dispersion layer 310_2 may include a stepped portion 310S stepped toward the second direction (Y direction) in a planar view. By the stepped portion 310S, the field dispersion layer 310_2 may have a protruding shape in a planar view toward the drain electrode 190. Accordingly, the width along the second direction (Y direction) of the field dispersion layer 310_2 may include a portion that decreases as it approaches the drain electrode 190. As another example, as illustrated in FIG. 13, the field dispersion layer 310_3 may have a trapezoidal shape in a planar view. Accordingly, the width along the second direction (Y direction) of the field dispersion layer 310_3 may decrease as the field dispersion layer 310_3 approaches the drain electrode 190. As another example, as illustrated in FIG. 14, the field dispersion layer 310_4 may include a protruding portion 310P convex toward the drain electrode 190. The protruding portion 310P may have a convex shape toward the drain electrode 190.

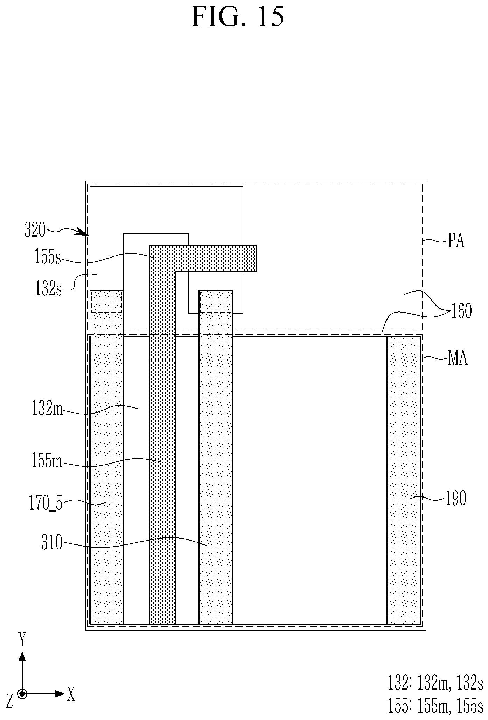

Referring to FIG. 15, a source electrode 170_5 of the semiconductor device may further extend into the peripheral circuit region PA. In some implementations, the source electrode 170_5 may extend in the second direction (Y direction) and be located in the main device region MA and the peripheral circuit region PA. The source electrode 170_5 may overlap the sub-channel layer 132s in the third direction (Z direction). The source electrode 170_5 may be connected to the sub-channel layer 132s in the peripheral circuit region PA.

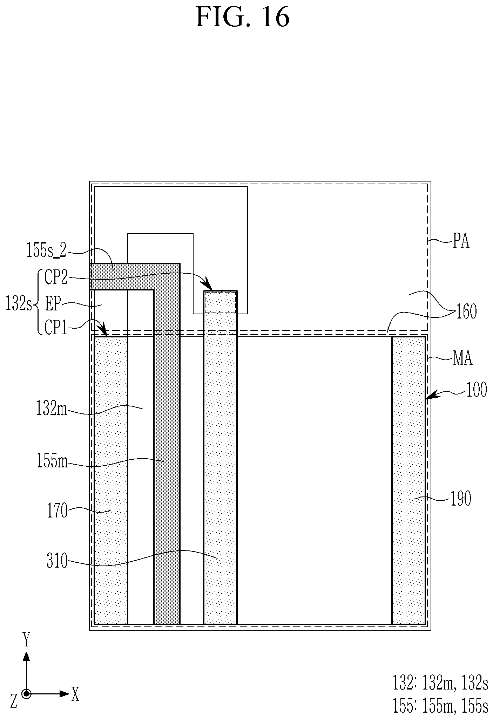

Referring to FIG. 16, the sub-gate electrode 155s_2 of the semiconductor device may have various shapes. For example, the sub-gate electrode 155s_2 may overlap the extension portion EP of the sub-channel layer 132s in the third direction (Z direction). In this case, the portion of the sub-gate electrode 155s_2 that overlaps the extension portion EP in the third direction (Z direction) may be located closer to the source electrode 170 than the field dispersion layer 310. In other words, the distance between the portion of the sub-gate electrode 155s_2 that overlaps the extension portion EP in the third direction (Z direction) and the first contact portion CP1 may be smaller than the distance between the portion of the sub-gate electrode 155s_2 that overlaps the extension portion EP in the third direction (Z direction) and the second contact portion CP2. However, the present disclosure is not limited thereto, and the extension portion EP and the portion of the sub-gate electrode 155s_2 overlapping in the third direction (Z direction) may be located further from the source electrode 170 than the field dispersion layer 310, or may be located substantially the same distance from the source electrode 170.

Referring to FIG. 17, the sub-channel layer 132s of the semiconductor device may be spaced apart from the main channel layer 132m.

In some implementations, the sub-channel layer 132s may be spaced apart from the main channel layer 132m in the second direction (Y direction), but other variations are not limited thereto. The separation structure 160 may be located between the sub-channel layer 132s and the main channel layer 132m. That is, the sub-channel layer 132s and the main channel layer 132m may be separated by the separation structure 160. In some implementations, the sub-channel layer 132s may have a square shape in a plane view, but the shape is not limited thereto.

Additionally, the source electrode 170, the sub-gate electrode 155s_3, and the field dispersion layer 310 of the semiconductor device may extend further into the peripheral circuit region PA.

For example, the source electrode 170, the sub-gate electrode 155s_3, and the field dispersion layer 310 may extend side-by-side. The source electrode 170, the sub-gate electrode 155s_3, and the field dispersion layer 310 may extend in the second direction (Y direction). The source electrode 170, the sub-gate electrode 155s_3 and the field dispersion layer 310 may be spaced apart from each other. The source electrode 170 and the field dispersion layer 310 may be connected with the sub-channel layer 132s. For example, the source electrode 170 may penetrate the first protective layer 140 and the barrier layer 136 to be connected with the first contact portion CP1 of the sub-channel layer 132s. The field dispersion layer 310 may penetrate the first protective layer 140 and the barrier layer 136 to be connected with the second contact portion CP2 of the sub-channel layer 132s. The source electrode 170 and the field dispersion layer 310 may overlap the separation structure 160 in the third direction (Z direction), but the relative positions are not limited thereto.

In some implementations, the sub-gate electrode 155s_3 may be located between the source electrode 170 and the field dispersion layer 310. The sub-gate electrode 155s_3 may overlap the sub-channel layer 132s in a third direction (z-direction). The sub-gate electrode 155s_3 may be located on the extension portion EP of the sub-channel layer 132s. That is, the sub-gate electrode 155s_3 may be located between the first contact portion CP1 and the second contact portion CP2 of the sub-channel layer 132s.

The field dispersion layer and the sub-transistor of the semiconductor device will be described below with reference to FIGS. 18 to 23.

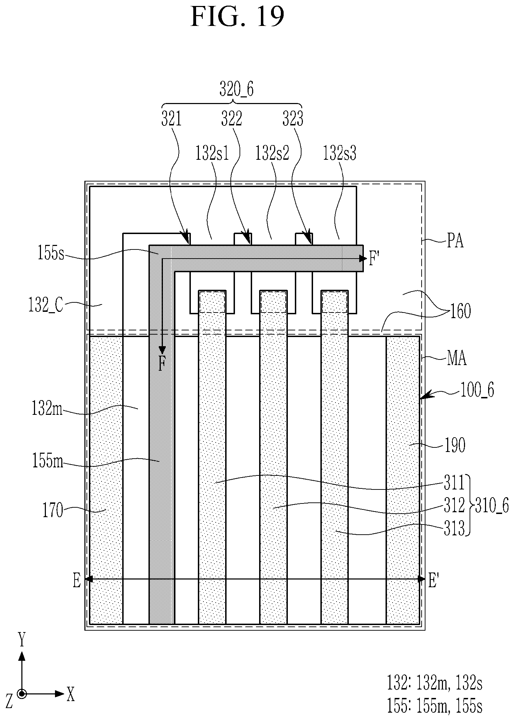

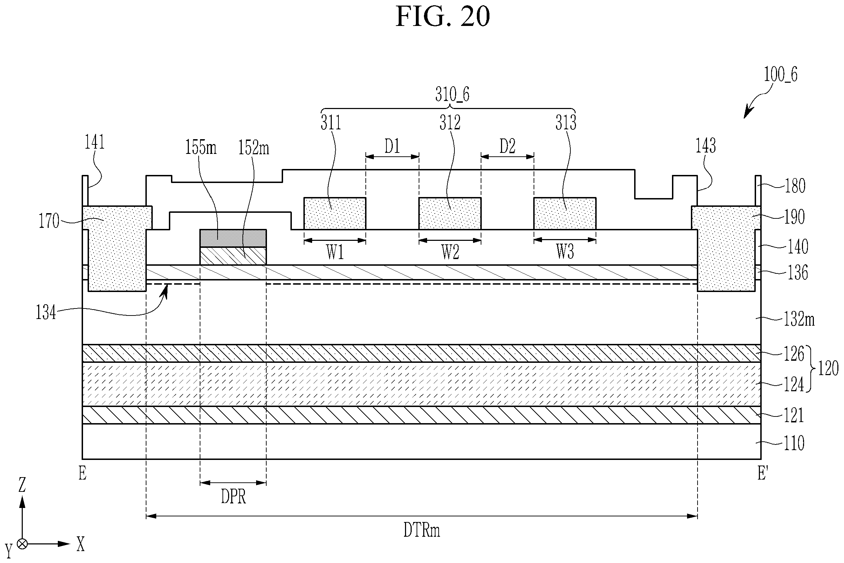

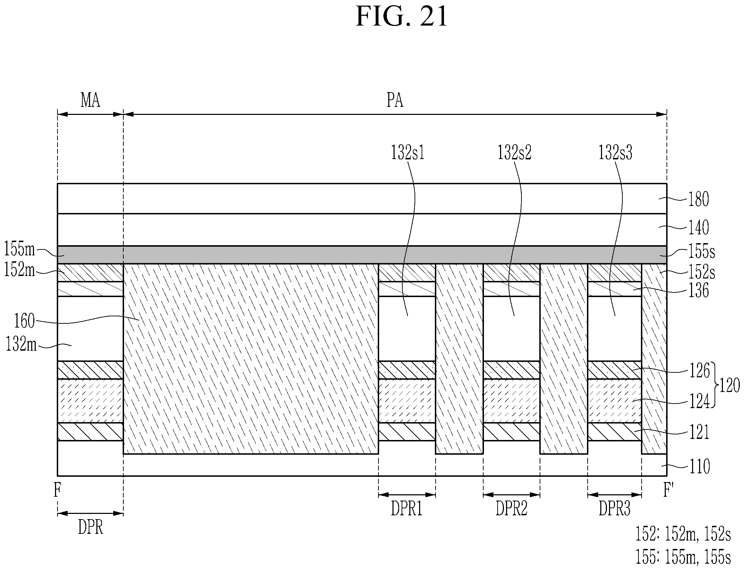

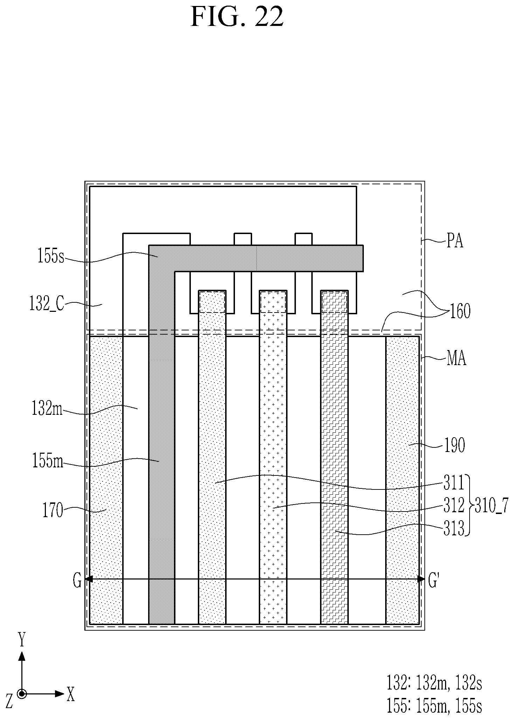

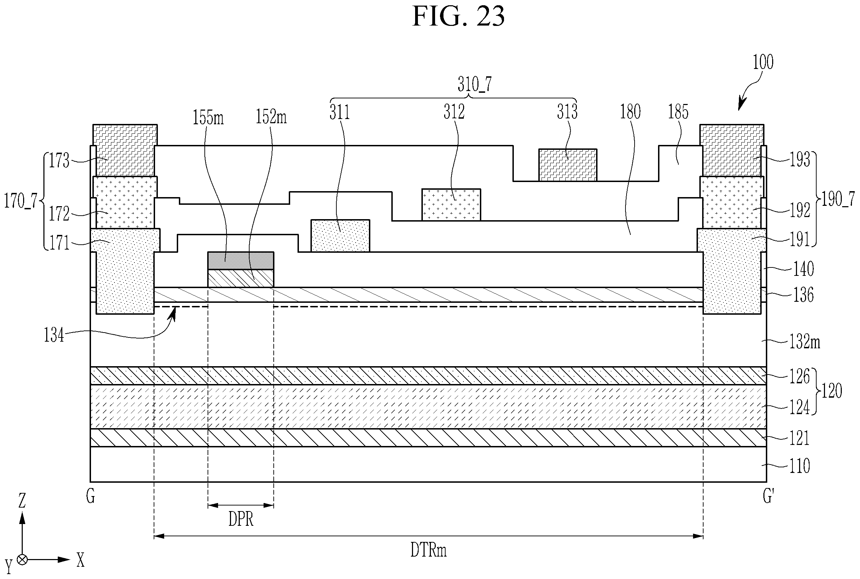

FIG. 18 is a circuit diagram illustrating an example of a semiconductor device. FIG. 19 is a top plan view illustrating an example of the semiconductor device of FIG. 18. FIG. 20 is a cross-sectional view taken along line E-E' of FIG. 19. FIG. 21 is a cross-sectional view taken along line F-F' of FIG. 19. FIGS. 19 to 21 are diagrams illustrating the semiconductor device of FIG. 18. FIGS. 22 and 23 are diagrams illustrating the semiconductor device of FIG. 18.

FIGS. 18 to 23 illustrate various modified examples of the semiconductor device illustrated in FIGS. 1 to 8. Since some parts of the examples illustrated in FIGS. 18 to 23 are substantially the same as those of the examples illustrated in FIGS. 1 to 8, a description thereof will be omitted, and the differences will be mainly described. Also, the same reference numerals are used for components that are identical to the preceding example.

Referring to FIG. 18, the field dispersion layer 310_6 of the semiconductor device may include a plurality of field dispersion layers 311 to 313. For example, the semiconductor device may include first to third field dispersion layers 311 to 313 located between the gate electrode G and the first electrode D of the main transistor 100_6. Additionally, the semiconductor device may include a plurality of sub-transistors 320_6. For example, the semiconductor device may include first to third sub-transistors 321 to 323 connected to the first to third field dispersion layers 311 to 313, respectively.

The first to third field dispersion layers 311 to 313 may serve to dissipate an electric field that is concentrated around the gate electrode G of the main transistor 100_6. Accordingly, the leakage current in the main transistor 100_6 may be reduced, and the breakdown voltage of the main transistor 100_6 may be increased.

Each of the first to third sub-transistors 321 to 323 may control the drain-to-source current in response to a gate signal applied to the gate electrode. Each of the first to third sub-transistors 321 to 323 may be electrically connected to one end of the main transistor 100_6. For example, a first electrode of each of the first to third sub-transistors 321 to 323 may be electrically connected to a second electrode S of the main transistor 100_6 and to a second power source supplying the second supply voltage V_{S}. Further, the second electrode of the first sub-transistor 321 may be electrically connected with the first field dispersion layer 311, the second electrode of the second sub-transistor 322 may be electrically connected with the second field dispersion layer 312, and the second electrode of the third sub-transistor 323 may be electrically connected with the third field dispersion layer 313.

Further, the gate electrodes of the first to third sub-transistors 321 to 323 may be electrically connected with the gate electrode G of the main transistor 100_6. Accordingly, the same signal may be applied to the gate electrodes of the first to third sub-transistors 321 to 323 and the gate electrode G of the main transistor 100_6, and the first to third sub-transistors 321 to 323 may be turned on depending on whether the main transistor 100_6 is turned on or not.

Referring now to FIGS. 19 to 21, an example of the semiconductor device includes first to third field dispersion layers 311 to 313 located between the main gate electrode 155m and the drain electrode 190, and first to third sub-transistors 321 to 323 connected with the first to third field dispersion layers 311 to 313, respectively.

The first to third field dispersion layers 311 to 313 may be located between the main gate electrode 155m and the drain electrode 190. For example, the first to third field dispersion layers 311 to 313 may be located sequentially in a direction away from the main gate electrode 155m. That is, the first field dispersion layer 311 may be located between the main gate electrode 155m and the second field dispersion layer 312, the second field dispersion layer 312 may be located between the first field dispersion layer 311 and the third field dispersion layer 313, and the third field dispersion layer 313 may be located between the second field dispersion layer 312 and the drain electrode 190.

The first to third field dispersion layers 311 to 313 may be spaced apart from each other. The first to third field dispersion layers 311 to 313 may extend in a side-by-side direction. The first to third field dispersion layers 311 to 313 may extend in a side-by-side direction with the main gate electrode 155m and the drain electrode 190. For example, but not limited to, the first to third field dispersion layers 311 to 313 may extend in the second direction (Y direction) and be spaced apart from each other. Further, the first to third field dispersion layers 311 to 313 may be spaced apart from the source electrode 170, the main gate electrode 155m, and the drain electrode 190.

In some implementations, the first to third field dispersion layers 311 to 313 may be located on the same layer as each other. For example, as illustrated in FIG. 20, the first to third field dispersion layers 311 to 313 may be located directly on the first protective layer 140. The first to third field dispersion layers 311 to 313 may be in contact with the top surface of the first protective layer 140. However, the present disclosure is not limited thereto, and the first to third field dispersion layers 311 to 313 may be located in different layers. These will be described hereinafter with reference to FIGS. 22 and 23.

In this case, a first distance D1 along the first direction (X direction) between the first field dispersion layer 311 and the second field dispersion layer 312 and a second distance D2 along the first direction (X direction) between the second field dispersion layer 312 and the third field dispersion layer 313 may be substantially the same, but the present disclosure is not limited thereto. Furthermore, the widths of the first to third field dispersion layers 311 to 313 may be substantially the same as each other. For example, a first width W1 along the first direction (X direction) of the first field dispersion layer 311, a second width W2 along the first direction (X direction) of the second field dispersion layer 312, and a third width W3 along the first direction (X direction) of the third field dispersion layer 313 may be substantially the same as each other, but are not limited thereto. As another example, at least one of the first width W1 along the first direction (X direction) of the first field dispersion layer 311, the second width W2 along the first direction (X direction) of the second field dispersion layer 312, and the third width W3 along the first direction (X direction) of the third field dispersion layer 313 may have a different width.

In some implementations, each of the first to third field dispersion layers 311 to 313 may be connected with the sub-channel layer 132s. For example, the first field dispersion layer 311 may be connected with the first sub-channel layer 132s1, the second field dispersion layer 312 may be connected with the second sub-channel layer 132s2, and the third field dispersion layer 313 may be connected with the third sub-channel layer 132s3. Here, the first to third sub-channel layers 132s1 to 132s3 may refer to the portion of the sub-channel layer 132s that configures the channel layers of the first to third sub-transistors 321 to 323.

Accordingly, each of the first to third field dispersion layers 311 to 313 may configure one electrode of one of the transistors. For example, the first field dispersion layer 311 may configure the one electrode of the first sub-transistor 321, the second field dispersion layer 312 may configure the one electrode of the second sub-transistor 322, and the third field dispersion layer 313 may configure the one electrode of the third sub-transistor 323.

In some implementations, the sub-channel layer 132s may include first to third sub-channel layers 132s1 to 132s3, each connected with one field dispersion layer 310_6, and a connection portion 132_C connected with the first to third sub-channel layers 132s1 to 132s3.

The first to third sub-channel layers 132s1 to 132s3 may be spaced apart from each other. For example, as illustrated in FIG. 19, the first to third sub-channel layers 132s1 to 132s3 may extend in the second direction (Y direction) and be spaced apart in the first direction (X direction), but the first to third sub-channel layers 132s1 to 132s3 are not limited thereto. The first to third sub-channel layers 132s1 to 132s3 may be connected with the first to third field dispersion layers 311 to 313. For example, the first field dispersion layer 311 may be connected to the first sub-channel layer 132s1 through the first protective layer 140 and the barrier layer 136, the second field dispersion layer 312 may be connected to the second sub-channel layer 132s2 through the first protective layer 140 and the barrier layer 136, and the third field dispersion layer 313 may be connected to the third sub-channel layer 132s3 through the first protective layer 140 and the barrier layer 136. Here, the first to third sub-channel layers 132s1 to 132s3 may refer to the portion of the sub-channel layer 132s that configures the channel layers of the first to third sub-transistors 321 to 323.

In some implementations, the connection portion 132_C may be connected to the source electrode 170. For example, the source electrode 170 may penetrate the first protective layer 140 and the barrier layer 136 to be connected with the connection portion 132_C. The connection portion 132_C may be connected to the first to third sub-channel layers 132s1 to 132s3. Accordingly, the first to third sub-channel layers 132s1 to 132s3 may be electrically connected to the source electrode 170 via the connection portion 132_C.

In some implementations, the sub-gate electrode 155s may be located above the first to third sub-channel layers 132s1 to 132s3. The sub-gate electrode 155s may overlap the first to third sub-channel layers 132s1 to 132s3 in a third direction (z-direction) and not overlap the connection portion 132_C in a third direction (z-direction), but the present disclosure is not limited thereto. The sub-gate electrode 155s may be located adjacent to the first to third field dispersion layers 311 to 313, but the relative location is not limited thereto. The sub-gate electrode 155s may extend to overlap the first to third sub-channel layers 132s1 to 132s3 in the third direction (Z direction). For example, the sub-gate electrode 155s may extend in the first direction (X direction) to overlap the first to third sub-channel layers 132s1 to 132s3 and the separation structure 160 in the third direction (Z direction). The sub-gate electrode 155s may be located between the portion of the sub-channel layer 132s to which the source electrode 170 is connected and the portion of the sub-channel layer 132s to which the first field dispersion layer 311 is connected, between the portion of the sub-channel layer 132s to which the source electrode 170 is connected and the portion of the sub-channel layer 132s to which the second field dispersion layer 312 is connected, and between the portion of the sub-channel layer 132s to which the source electrode 170 is connected and the portion of the sub-channel layer 132s to which the third field dispersion layer 313 is connected. The sub-gate electrode 155s may be spaced apart from the first to third field dispersion layers 311 to 313. The sub-gate electrode 155s may configure the gates of the first to third sub-transistors 321 to 323.

In some implementations, the sub-gate semiconductor layer 152s may be located between the barrier layer 136 and the sub-gate electrode 155s. The sub-gate semiconductor layer 152s may be located on the first to third sub-channel layers 132s1 to 132s3. The sub-gate semiconductor layer 152s may overlap the first to third sub-channel layers 132s1 to 132s3 in the third direction (Z direction). For example, as illustrated in FIG. 21, the sub-gate semiconductor layer 152s may overlap each of the first to third sub-channel layers 132s1 to 132s3 in the third direction (Z direction). The sub-gate semiconductor layers 152s located on each of the first to third sub-channel layers 132s1 to 132s3 may be spaced apart from each other. The separation structure 160 may be located between the sub-gate semiconductor layers 152s located on the first to third sub-channel layers 132s1 to 132s3, respectively. The sub-gate semiconductor layers 152s located on each of the first to third sub-channel layers 132s1 to 132s3 may be separated from each other by the separation structure 160, but the present disclosure is not limited thereto. The sub-gate semiconductor layers 152s located on each of the first to third sub-channel layers 132s1 to 132s3 may not overlap the separation structure 160 in the third direction (Z direction), but the present disclosure is not limited thereto.

The depletion region DPR may be formed in the sub-channel layer 132s by the sub-gate semiconductor layer 152s. For example, as illustrated in FIG. 21, a first depletion region DPR1 may be formed in the first sub-channel layer 132s1 by the sub-gate semiconductor layer 152s, a second depletion region DPR2 may be formed in the second sub-channel layer 132s2, and a third depletion region DPR3 may be formed in the third sub-channel layer 132s3. The first to third depletion regions DPR1 to DPR3 may refer to regions where the flow of the two-dimensional electron gas 134 is interrupted within the sub-drift region DTRs.

The sub-gate electrode 155s of the semiconductor device may overlap each of the first to third sub-channel layers 132s1 to 132s3 configuring the channel layers of the first to third sub-transistors 321 to 323 in the third direction (Z direction). Thus, the first to third sub-transistors 321 to 323 may be turned on or turned off together depending on a gate signal applied to the sub-gate electrode 155s. The method of operating the first to third sub-transistors 321 to 323 is substantially the same as the method of operating the sub-transistor 320 of the examples of FIGS. 1 to 8, and therefore will be omitted.

Referring to FIGS. 22 and 23, the semiconductor device may further include a third protective layer 185 located on the second protective layer 180. The field dispersion layer 310_7 of the semiconductor device may include a plurality of field dispersion layers 311 to 313, and the first to third field dispersion layers 311 to 313 may be located on different layers.

Additionally, the semiconductor device may include the plurality of source electrodes 170_7 and the plurality of drain electrodes 190_7. For example, the source electrode 170_7 may include first to third source electrodes 171 to 173 stacked sequentially in the third direction (Z direction) on top of the main channel layer 132m, and the drain electrode 190_7 may include first to third drain electrodes 191 to 193 stacked sequentially in the third direction (Z direction) on top of the main channel layer 132m.

For example, the first field dispersion layer 311 may be located on the first protective layer 140. The first field dispersion layer 311 may be located directly on the top surface of the first protective layer 140. The first field dispersion layer 311 may be covered by the second protective layer 180. For example, the top surface and the lateral surface of the first field dispersion layer 311 may be covered by the second protective layer 180. In this case, the first field dispersion layer 311 may be located in the same layer as at least a portion of the first source electrode 171. For example, the portion of the first source electrode 171 that is located on the first protective layer 140 may be located in the same layer as the first field dispersion layer 311, but the present disclosure is not limited thereto. The first field dispersion layer 311 may include the same material as the first source electrode 171. The first field dispersion layer 311 may be formed together by the same process as the first source electrode 171. However, the present disclosure is not limited thereto, and the first field dispersion layer 311 may include a different material from the first source electrode 171 and/or may be formed by a different process.

The second field dispersion layer 312 may be located on the second protective layer 180. The second field dispersion layer 312 may be located directly on the top surface of the second protective layer 180. The second field dispersion layer 312 may be covered by the third protective layer 185. For example, the top surface and the lateral surface of the second field dispersion layer 312 may be covered by the third protective layer 185. In this case, the second field dispersion layer 312 may be located in the same layer as at least a portion of the second source electrode 172. For example, the portion of the second source electrode 172 that is located on the second protective layer 180 may be located in the same layer as the second field dispersion layer 312, but the present disclosure is not limited thereto. The second field dispersion layer 312 may include the same material as the second source electrode 172. The second field dispersion layer 312 may be formed together by the same process as the second source electrode 172. However, the present disclosure is not limited thereto, and the second field dispersion layer 312 may comprise a different material from the second source electrode 172, or may be formed by a different process.

The third field dispersion layer 313 may be located on the third protective layer 185. The third field dispersion layer 313 may be located directly on the top surface of the third protective layer 185. In this case, the third field dispersion layer 313 may be located in the same layer as at least a portion of the third source electrode 173. For example, the portion of the third source electrode 173 located above the third protective layer 185 may be located in the same layer as the third field dispersion layer 313, but the present disclosure is not limited thereto. The third field dispersion layer 313 may include the same material as the third source electrode 173. The third field dispersion layer 313 may be formed together by the same process as the third source electrode 173. However, the present disclosure is not limited thereto, and the third field dispersion layer 313 may include a different material from the third source electrode 173, or may be formed by a different process.

As another example, FIG. 22 and FIG. 23 depict another semiconductor device. In FIG. 23, the first to third field dispersion layers 311 to 313 are illustrated as being located in different layers, but the present disclosure is not limited thereto, and at least one of the first to third field dispersion layers 311 to 313 may be located in a different layer.

The examples of FIGS. 18 to 23 describe three field dispersion layers 310, but the number of field dispersion layers 310 is not limited thereto. For example, a semiconductor device may include two field dispersion layers 310, or may include four or more field dispersion layers 310.

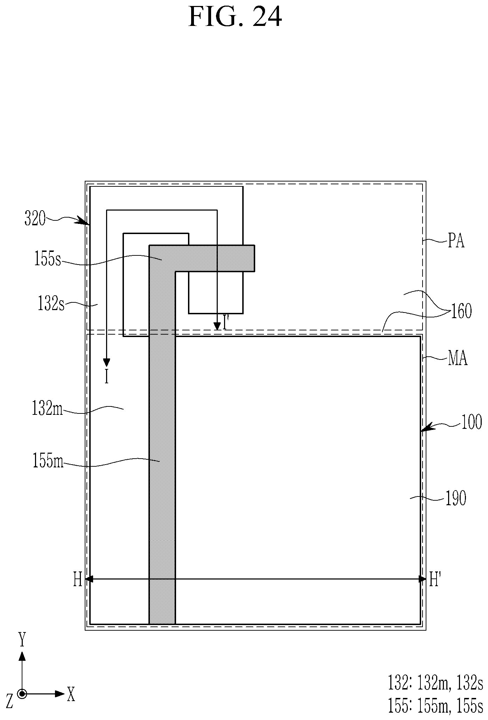

Hereinafter, an example of a method of manufacturing a semiconductor device will be described with reference to FIGS. 24 to 30.

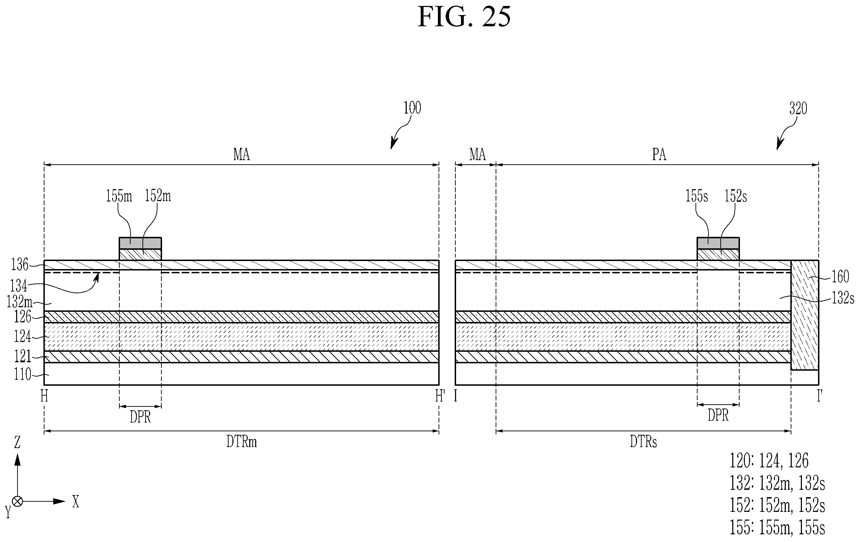

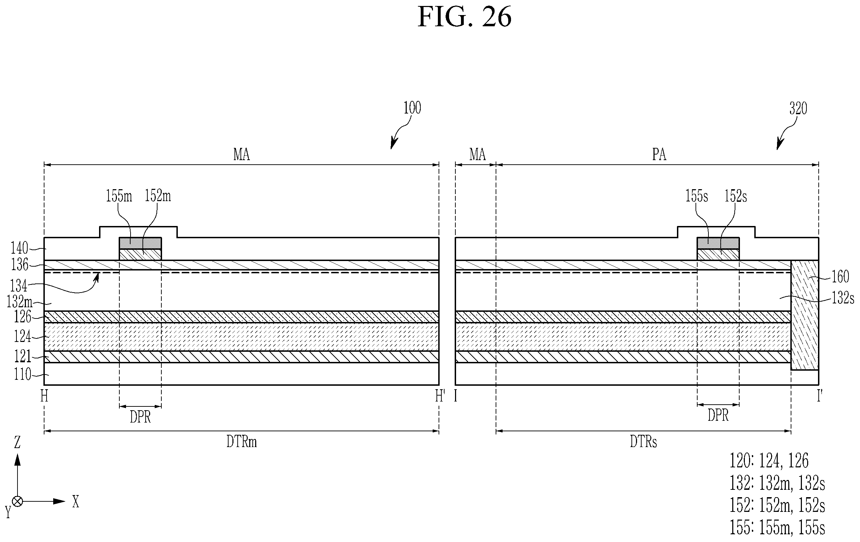

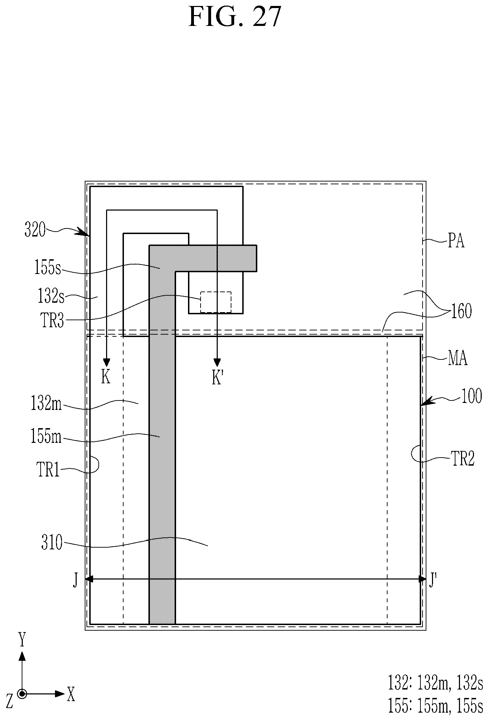

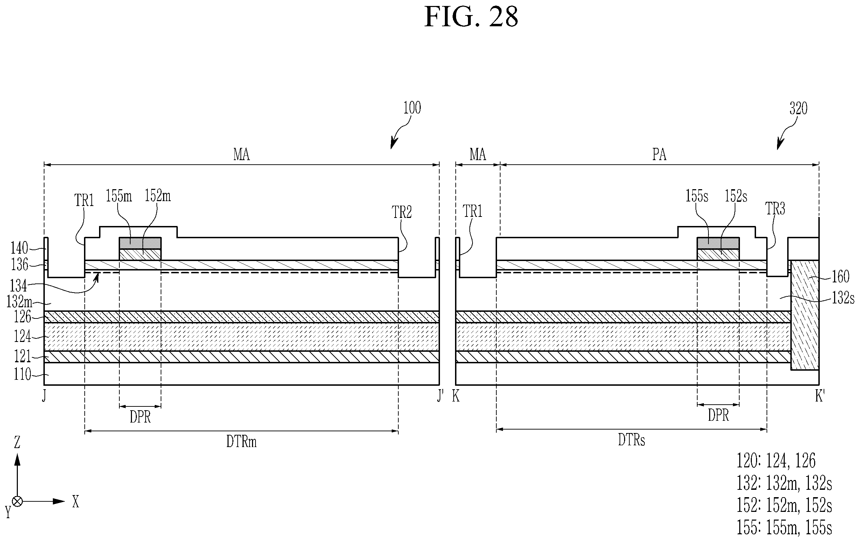

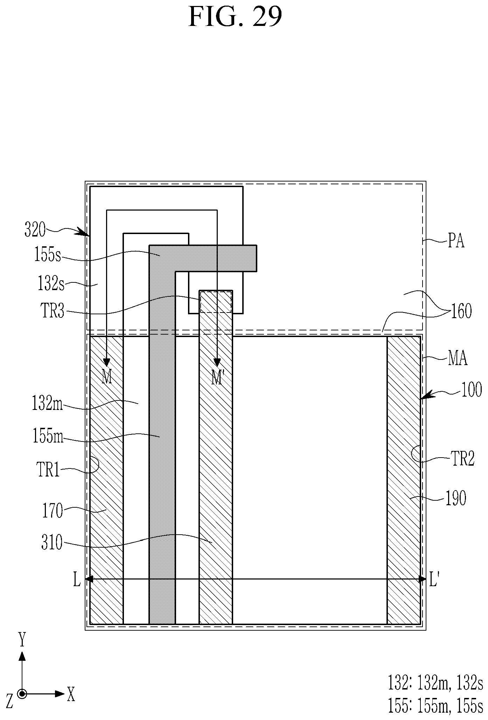

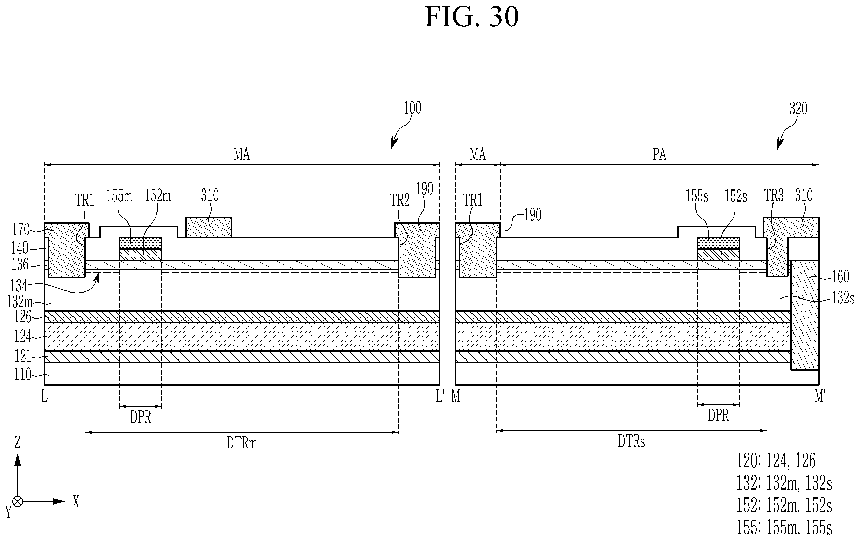

FIG. 24 is a top plan view of an intermediate operation illustrating an example of a method of manufacturing a semiconductor device. FIG. 25 is an example of a cross-sectional view taken along lines H-H' and I-I' of FIG. 24. FIG. 26 is another example of a cross-sectional view corresponding to H-H' and I-I' of FIG. 24. FIG. 27 is a top plan view of an example of another intermediate operation illustrating the method of manufacturing the semiconductor device. FIG. 28 is a cross-sectional view taken along lines J-J' and K-K' of FIG. 27. FIG. 29 is a top plan view of an example of another intermediate operation illustrating the method of manufacturing the semiconductor device. FIG. 30 is a cross-sectional view taken along lines L-L' and M-M' of FIG. 29.

As illustrated in FIGS. 24 and 25, a seed layer 121, a buffer layer 120, a channel layer 132, and a barrier layer 136, a gate semiconductor material layer may be formed sequentially on a substrate 110, a separation isolation structure 160 may be formed, and a gate electrode 155 and a gate semiconductor layer 152 may be formed.

First, the seed layer 121 and the buffer layer 120 may be formed sequentially on the substrate 110 in the main device region MA and a peripheral circuit region PA. In this example, the buffer layer 120 may include a superlattice layer 124 and a high-resistance layer 126.

The substrate 110 may include a semiconductor material. For example, the substrate 110 may include sapphire, Si, SiC, AlN, GaN, or combinations thereof. The substrate 110 may also be a silicon on insulator (SOI) substrate. However, the material of the substrate 110 is not limited thereto, and any commonly used substrate may be applied.

The seed layer 121 and the superlattice layer 124 may be formed sequentially using an epitaxial growth method. The seed layer 121 and the superlattice layer 124 may be made of the same base semiconductor material. However, the material composition ratio of each layer may be different in consideration of the role of each layer, the performance required of the semiconductor device, and the like. The seed layer 121 and the superlattice layer 124 may include one or more materials selected from group III-V materials, for example, nitrides comprising Al, Ga, In, B, or combinations thereof. The seed layer 121 and the superlattice layer 124 may be AlₓIn_{y}Ga_{1-x-y}N (0≤x≤1, 0≤y≤1, x+y≤1). For example, the seed layer 121 and the superlattice layer 124 may include AlN, GaN, InN, InGaN, AlGaN, AlInN, AlInGaN, or a combination thereof.

In this example, the superlattice layer 124 may be formed of multiple layers in which layers including different materials are stacked alternately. For example, the superlattice layer 124 may have the structure in which layers of AlGaN and layers of AlN are repeatedly stacked. That is, AlGaN/AlN/AlGaN/AlN/AlGaN/AlN/ may be stacked sequentially to form the superlattice layer 124.

The high-resistance layer 126 may be made of a low-conductivity material such that the substrate 110 and the channel layer 132m are electrically isolated. The high-resistance layer may include one or more materials selected from group III-V materials, for example, nitrides including Al, Ga, In, B, or combinations thereof. The high-resistance layer 126 may be AlₓIn_{y}Ga_{1-x-y}N (0≤x≤1, 0≤y≤1, x+y≤1). For example, the high-resistance layer 126 may include AlN, GaN, InN, InGaN, AlGaN, AlInN, AlInGaN, or combinations thereof. The high-resistance layer 126 may be a single layer or multiple layers.

Subsequently, the channel layer 132 and the barrier layer 136 may be formed sequentially on top of the high-resistance layer 126 in the main device region MA and the peripheral circuit region PA.

In this example, the channel layer 132 and the barrier layer 136 may be formed sequentially using an epitaxial growth method. For example, the channel layer 132 may be formed on top of the high-resistance layer 126, and the barrier layer 136 may be formed on top of the channel layer 132.

The channel layer 132 and the barrier layer 136 may be made of the same base semiconductor material. However, the material composition ratio of each layer may be different based on the role of each layer, the performance required of the semiconductor device, etc. The channel layer 132 and the barrier layer 136 may include one or more materials selected from group III-V materials, for example, nitrides including Al, Ga, In, B, or combinations thereof. The channel layer 132 and the barrier layer 136 may be AlₓIn_{y}Ga_{1-x-y}N (0≤x≤1, 0≤y≤1, x+y≤1). For example, the channel layer 132 and the barrier layer 136 may include AlN, GaN, InN, InGaN, AlGaN, AlInN, AlInGaN, or combinations thereof. The barrier layer 136 may include a material having a different energy band gap than that of the channel layer 132. The barrier layer 136 may have a higher energy band gap than that of the channel layer 132.

In one example, the substrate 110 may include Si, the seed layer 121 may include AlN, and the superlattice layer 124 may include AlGaN and AlN. The high-resistance layer 126 may include GaN, the channel layer 132 may include GaN, and the barrier layer 136 may include AlGaN. The channel layer 132 and the barrier layer 136 may be doped with impurities or may be undoped.

Next, a gate semiconductor material layer may be formed on top of the barrier layer 136. The gate semiconductor material layer may be formed using an epitaxial growth method.

Then, an ion implantation process may be performed to form the separation structure 160 to separate the main channel layer 132m and the sub-channel layer 132s from each other.

For example, the separation structure 160 may be formed by performing the ion implantation process on a portion of the gate semiconductor material layer and a portion of the barrier layer 136 located between the main device region MA and the peripheral circuit region PA. In this case, the ion implantation process may be performed on at least a portion of the channel layer 132, the buffer layer 120, the seed layer 121, and the substrate 110 together. The separation structure 160 may penetrate the gate semiconductor material layer, the barrier layer 136, the channel layer 132, the buffer layer 120, and the seed layer 121 to recess at least a portion of the substrate 110, but the present disclosure is not limited thereto.

As the separation structure 160 is formed, the channel layer 132 may be separated into the main channel layer 132m and the sub-channel layer 132s. However, the present disclosure is not limited thereto, and the main channel layer 132m and the sub-channel layer 132s may also be separated from each other by forming a trench through the gate semiconductor material layer and the barrier layer 136 between the main device region MA and the peripheral circuit region PA.

Next, a gate electrode material layer may be formed on top of the gate semiconductor material layer in the main device region MA and the peripheral circuit region PA, and the gate semiconductor material layer and the gate electrode material layer may be patterned to form the gate electrode 155 and the gate semiconductor layer 152.

Specifically, the gate electrode material layer may be formed using a deposition process. For example, the gate electrode material layer may be formed using at least one of, but not limited to, electron beam evaporation (E-beam evaporation), sputtering, physical vapor deposition (PVD), thermal chemical vapor deposition (thermal CVD), low pressure chemical vapor deposition (LP-CVD), plasma enhanced chemical vapor deposition (PE-CVD), or atomic layer deposition (ALD) techniques.

The gate electrode material layer and the gate semiconductor material layer may then be patterned using a photolithography and etch process to form the gate electrode 155 and the gate semiconductor layer 152. For example, a hard mask layer may be formed on the gate electrode material layer, and then at least a portion of the gate semiconductor material layer may be removed by etching the gate semiconductor material layer using the hard mask layer as a mask. Accordingly, the portion of the gate electrode material layer that remains may become the gate electrode 155. Further, the portion of the gate semiconductor material layer that remains may be the gate semiconductor layer 152. The gate semiconductor layer 152 may be located between the barrier layer 136 and the gate electrode 155. However, the present disclosure is not limited thereto, and the gate electrode 155 and the gate semiconductor layer 152 may also be formed by utilizing a photoresist pattern in addition to the hard mask layer, or by patterning without utilizing the hard mask layer. The gate electrode 155 may be in Schottky contact or ohmic contact with the gate semiconductor layer 152.

In this case, the portion of the gate electrode 155 located in the main device region MA may be referred to as the main gate electrode 155m, and the portion of the gate electrode 155 located in the peripheral circuit region PA may be referred to as the sub-gate electrode 155s. Further, the portion of the gate semiconductor layer located in the main device region MA may be referred to as a main gate semiconductor layer 152m, and the portion of the gate semiconductor layer located in the peripheral circuit region PA may be referred to as a sub-gate semiconductor layer 152s.

As illustrated in FIG. 26, a first protective layer 140 may be formed on the barrier layer 136 and the gate electrode 155. For example, the first protective layer 140 may be formed to cover the barrier layer 136 in the main device region MA and the gate electrode 155 and the barrier layer 136 in the peripheral circuit region PA. Further, a first protective layer 140 may be formed on the separation structure 160. The first protective layer 140 may include an insulating material. For example, the first protective layer 140 may include an oxide, such as SiO₂ or Al₂O₃. As another example, the first protective layer 140 may include a nitride, such as SiN, or an oxynitride, such as SiON.

As illustrated in FIGS. 27 and 28, by patterning the first protective layer 140 using a photo and etch process, a first trench TR1 and a second trench TR2 may be formed in the main device region MA, and a third trench TR3 may be formed in the peripheral circuit region PA. At this time, the first protective layer 140, as well as the barrier layer 136 and the channel layer 132, may be patterned together.

For example, a photoresist pattern may be formed on the first protective layer 140 and used as a mask to sequentially etch the first protective layer 140, the barrier layer 136, and the channel layer 132. At this time, the first protective layer 140 and the barrier layer 136 may be penetrated by the first trench TR1 and the second trench TR2, and the top surface of the main channel layer 132m may be recessed. The main channel layer 132m may not be penetrated by the first trench TR1 or the second trench TR2. Additionally, the first protective layer 140 and the barrier layer 136 may be penetrated by the third trench TR3, and the top surface of the sub-channel layer 132s may be recessed. The sub-channel layer 132s, in this example, may not be penetrated by the third trench TR3.

In this case, the depth at which the top surface of the main channel layer 132m and the top surface of the sub-channel layer 132s are recessed may be much smaller compared to the overall thickness of the main channel layer 132m. Further, the depth at which the top surface of the main channel layer 132m and the top surface of the sub-channel layer 132s are recessed may be small relative to the thickness of the barrier layer 136. However, the present disclosure is not limited thereto, and the depth at which the top surface of the main channel layer 132m and the top surface of the sub-channel layer 132s are recessed may be varied.

By the first trench TR1 and the second trench TR2, the lateral surface of the first protective layer 140 and the barrier layer 136 may be exposed to the outside, and the top surface and the lateral surface of the main channel layer 132m may be exposed. The lateral surface of the sub-channel layer 132s may be exposed by the first trench TR1. The main channel layer 132m and the sub-channel layer 132s may form the bottom surface and the lateral wall of the first trench TR1, and the barrier layer 136 may form the lateral wall of the first trench TR1. The main channel layer 132m may form the bottom surface and the lateral wall of the second trench TR2, and the barrier layer 136 may form the lateral wall of the second trench TR2.

By the third trench TR3, the lateral surfaces of the first protective layer 140 and the barrier layer 136 may be exposed to the outside, and the top surface and the lateral surface of the sub-channel layer 132s may be exposed. The sub channel layer 132s may form the bottom surface and the lateral wall of the third trench TR3, and the barrier layer 136 may form the lateral wall of the third trench TR3.

The first trench TR1 and the second trench TR2 may be spaced apart from each other. The first trench TR1 and the second trench TR2 may be located on opposite sides of the gate electrode 155. The first trench TR1 may be located on one side of the gate electrode 155 while being spaced apart from the gate electrode 155. The second trench TR2 may be located on the other side of the gate electrode 155 while being spaced apart from the gate electrode 155. The distance by which the first trench TR1 is spaced from the gate electrode 155 may be less than the distance by which the second trench TR2 is spaced from the gate electrode 155. The first trench TR1 and the second trench TR2 are illustrated as having similar shapes, such as widths and depths, but are not limited thereto. The shapes of the first trench TR1 and the second trench TR2 may be varied.

As illustrated in FIG. 29 and 30, a conductive material may be deposited within the first trench TR1 to the third trench TR3, and patterned to form a source electrode 170, a drain electrode 190, and a field dispersion layer 310.

In this example, the source electrode 170 may be formed to fill the interior of the first trench TR1. Within the first trench TR1, the source electrode 170 may be in contact with the main channel layer 132m and the barrier layer 136. The source electrode 170 may be in contact with the lateral surfaces of the main channel layer 132m and the barrier layer 136. The source electrode 170 may cover the lateral surfaces of the main channel layer 132m and the barrier layer 136. The source electrode 170 may be electrically connected to the main channel layer 132m via the first trench TR1. Additionally, the source electrode 170 may be electrically connected to the sub-channel layer 132s via the first trench TR1. The top surface of the source electrode 170 may protrude above the top surface of the first protective layer 140.

The drain electrode 190 may be formed to fill the interior of the second trench TR2. Within the second trench TR2, the drain electrode 190 may be in contact with the main channel layer 132m and the barrier layer 136. The drain electrode 190 may be in contact with the lateral surfaces of the main channel layer 132m and the barrier layer 136. The drain electrode 190 may cover the lateral surfaces of the main channel layer 132m and the barrier layer 136. The drain electrode 190 may be electrically connected to the main channel layer 132m via the second trench TR2. The top surface of the drain electrode 190 may protrude above the top surface of the first protective layer 140.

The source electrode 170 and the drain electrode 190 may be in ohmic contact with the main channel layer 132m. Within the main channel layer 132m, the regions in contact with the source electrode 170 and the drain electrode 190 may be doped at relatively high concentrations compared to other regions. For example, the main channel layer 132m or the barrier layer 136 may be doped by an ion implantation process, an annealing process, or the like. However, the present disclosure is not limited thereto, and the doping process of the main channel layer 132m or the barrier layer 136 may be accomplished by a variety of other processes. The doping process of the main channel layer 132m or the barrier layer 136 may be performed prior to forming the source electrode 170 and the drain electrode 190, but the present disclosure is not limited thereto. In some cases, the main channel layer 132m and/or the barrier layer 136 may not be doped.

In this example, the field dispersion layer 310 may be formed to fill the interior of the third trench TR3. The field dispersion layer 310 may be formed between the source electrode 170 and the drain electrode 190. Additionally, the field dispersion layer 310 may be formed between the main gate electrode 155m and the drain electrode 190. The field dispersion layer 310 may be formed to extend on the first protective layer 140 in the same direction as the source electrode 170 and the drain electrode 190. The field dispersion layer 310 may be formed to be spaced apart from the source electrode 170 and the drain electrode 190. For example, the field dispersion layer 310 may extend in the second direction (Y direction) and be spaced apart from the source electrode 170 and the drain electrode 190 in the first direction (X direction), but is not limited thereto. Within the third trench TR3, the field dispersion layer 310 may be in contact with the sub-channel layer 132s. The field dispersion layer 310 may be in contact with the lateral surfaces of the sub-channel layer 132s and the barrier layer 136. The field dispersion layer 310 may be electrically connected to the sub-channel layer 132s via the third trench TR3. The field dispersion layer 310 may include, but is not limited to, the same material as the source electrode 170 and the drain electrode 190.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Although examples of the present disclosure have been described in detail, the scope of the present disclosure is not limited by the examples. Various changes and modifications using the basic concept of the present disclosure defined in the accompanying claims by those skilled in the art shall be construed to belong to the scope of the present disclosure.

Embodiments are described in the following clauses:
Clause 1 A semiconductor device comprising:
   a main channel layer;
   a gate electrode located on the main channel layer;
   a gate semiconductor layer between the main channel layer and the gate electrode;
   a source electrode and a drain electrode on opposite sides of the gate electrode and connected to the main channel layer;
   a field dispersion layer on the main channel layer, and between the gate electrode and the drain electrode; and
   a sub-channel layer including a drift region having two-dimensional electron gas, wherein the sub-channel layer includes a first contact portion connected with the source electrode, a second contact portion connected with the field dispersion layer, and an extension portion connecting the first contact portion and the second contact portion,
   wherein the gate electrode overlaps the extension portion of the sub-channel layer in a thickness direction of the sub-channel layer.
Clause 2 The semiconductor device of clause 1, wherein the field dispersion layer is spaced apart from the source electrode and the gate electrode in a thickness direction with the sub-channel layer.
Clause 3 The semiconductor device of clause 1 or clause 2, comprising:
   a barrier layer located between the main channel layer and the gate semiconductor layer and including a material having a different energy band gap from the main channel layer; and
   a first protective layer covering the gate electrode and the barrier layer,
   wherein the field dispersion layer is on the first protective layer.
Clause 4 The semiconductor device of clause 3, wherein the field dispersion layer penetrates the first protective layer and the barrier layer, and is connected to the second contact portion of the sub-channel layer, and
   wherein the source electrode penetrates the first protective layer and the barrier layer, and is connected to the first contact portion of the sub-channel layer.
Clause 5 A semiconductor device comprising:
   a main transistor including
      a main channel layer including GaN,
      a barrier layer on the main channel layer and including AlGaN,
      a main gate electrode on the barrier layer,
      a main gate semiconductor layer between the main channel layer and the main gate electrode and including GaN doped with p-type impurities,
      a source electrode and a drain electrode on opposite sides of the main gate electrode and connected to the main channel layer,
      a first protective layer on the main gate electrode and the barrier layer, and
      a field dispersion layer on the first protective layer, and between the main gate electrode and the drain electrode; and
   a sub-transistor connected to a first end of the main transistor, wherein the sub-transistor includes:
      a sub-channel layer on one side of the main channel layer, including the same material as the main channel layer, and including a first contact portion penetrating the barrier layer to be connected with the source electrode, a second contact portion penetrating the first protective layer and the barrier layer to be connected with the field dispersion layer, and an extension portion connecting the first contact portion and the second contact portion, and
      a sub-gate electrode on the extension portion of the sub-channel layer, connected to the main gate electrode, and including the same material as the main gate electrode.

### <Description of symbols>

100: Main transistor
320: Sub- transistor
110: Substrate
132m: Main channel layer
132s: Sub-channel layer
136: Barrier layer
152: Gate semiconductor layer
155m: Main gate electrode
170: Source electrode
190: Drain electrode
310: Field dispersion layer
140: First protective layer

## Claims

1. A semiconductor device comprising:
a main transistor including
a main channel layer,
a main gate electrode on the main channel layer,
a main gate semiconductor layer between the main channel layer and the main gate electrode,
a source electrode and a drain electrode on opposite sides of the main gate electrode and connected to the main channel layer, and
a field dispersion layer on the main channel layer, and located between the main gate electrode and the drain electrode; and
a sub-transistor connected to a first end of the main transistor, wherein the sub-transistor includes
a sub-channel layer including a drift region having two-dimensional electron gas, and including a first contact portion connected with the source electrode, a second contact portion connected with the field dispersion layer, and an extension portion connecting the first contact portion and the second contact portion, and
a sub-gate electrode located on the extension portion of the sub-channel layer and connected with the main gate electrode.

2. The semiconductor device of claim 1, wherein the field dispersion layer and the source electrode are elongated in the same direction, wherein the field dispersion layer is spaced apart from the source electrode.

3. The semiconductor device of claim 1 or claim 2, further comprising:
a barrier layer between the main channel layer and the main gate semiconductor layer, and including a material having a different energy band gap from the main channel layer; and
a first protective layer covering the main gate electrode and the barrier layer,
wherein the field dispersion layer is on the first protective layer.

4. The semiconductor device of claim 3, wherein the barrier layer and the first protective layer are on the sub-channel layer.

5. The semiconductor device of claim 4, wherein
the field dispersion layer penetrates the first protective layer and the barrier layer, and is connected to the second contact portion of the sub-channel layer, and
wherein the source electrode penetrates the first protective layer and the barrier layer, and is connected to the first contact portion of the sub-channel layer.

6. The semiconductor device of claim 5, comprising
a separation structure between the main channel layer and the sub-channel layer,
wherein at least a portion of the field dispersion layer overlaps the separation structure in a thickness direction of the sub-channel layer.

7. The semiconductor device of any preceding claim, comprising a sub-gate semiconductor layer between the sub-channel layer and the sub-gate electrode, wherein the sub-gate semiconductor layer is in the same layer as the main gate semiconductor layer and includes the same material as the main gate semiconductor layer.

8. The semiconductor device of claim 7, wherein the sub-gate semiconductor layer includes the same material as the main gate semiconductor layer, and
wherein the main gate electrode and the sub-gate electrode are integrally formed as a single piece.

9. The semiconductor device of claim 8, further comprising
a separation structure between the main channel layer and the sub-channel layer,
wherein the separation structure is between the sub-gate semiconductor layer and the main gate semiconductor layer.

10. The semiconductor device of any preceding claim, wherein the main gate electrode and the sub-gate electrode are in the same layer, include the same material, and are integrally formed as a single piece.

11. The semiconductor device of any preceding claim, wherein the source electrode includes the same material as the field dispersion layer and includes a portion in the same layer as the field dispersion layer.

12. The semiconductor device of any preceding claim, wherein at least a portion of the field dispersion layer overlaps the sub channer layer in a thickness direction of the sub-channel layer.

13. The semiconductor device of any preceding claim 1, wherein the field dispersion layer
includes:
a first field dispersion layer on one side of the gate electrode; and
a second field dispersion layer between the first field dispersion layer and the drain electrode,
wherein each of the first field dispersion layer and the second field dispersion layer is connected to the sub-channel layer and is electrically connected to the source electrode.

14. The semiconductor device of claim 13, further comprising:
a barrier layer between the main channel layer and the main gate semiconductor layer, and including a material having a different energy band gap from the main channel layer;
a first protective layer covering the main gate electrode and the barrier layer; and
a second protective layer on the first protective layer,
wherein the first field dispersion layer is on the first protective layer, and the second field dispersion layer is on the second protective layer.

15. The semiconductor device of claim 14, wherein the source electrode includes:
a first source electrode penetrating the first protective layer and on the sub-channel layer; and
a second source electrode penetrating the second protective layer and on the first source electrode,
wherein the first source electrode includes the same material as the first field dispersion layer, and
wherein the second source electrode includes the same material as the second field dispersion layer.
